# EUROPEAN PATENT SPECIFICATION

(11) **EP 2 082 437 B1**
(45) Date of publication and mention of the grant of the patent: **02.01.2019**
(21) Application number: 07872313.7
(22) Date of filing: 01.10.2007
(51) Int. Cl.: H01L 51/46, H01L 27/30

(54) **PHOTOVOLTAIC CELL WITH SILOLE-CONTAINING CO-POLYMER**
FOTOVOLTAISCHE ZELLE MIT SILOLHALTIGEM CO-POLYMER
CELLULE PHOTOVOLTAÏQUE AVEC UN CO-POLYMÈRE CONTENANT DES SILOLES

(30) Priority: 11.10.2006 US 850963 P
(43) Date of publication of application: 29.07.2009
(73) Proprietor: Merck Patent GmbH, 64293 Darmstadt (DE)
(72) Inventor: GAUDIANA, Russell, Merrimack, New Hampshire 03054 (US); KINGSBOROUGH, Richard, North Chelmsford, Massachusetts 01863 (US); SHI, Xiaobo, Manchester, New Hampshire 03102 (US); WALLER, David, Lexington, Massachusetts 02420 (US); ZHU, Zhengguo, Chelmsford, Massachusetts 01824 (US)
(86) International application number: PCT/US2007/080053
(87) International publication number: WO 2008/088595

(56) References cited:
- US-A1- 2004 201 018
- US-A1- 2006 155 106
- LIU M S ET AL: "Efficient green-light-emitting diodes from silole-containing copolymers", CHEMISTRY OF MATERIALS, AMERICAN CHEMICAL SOCIETY, WASHINGTON, US, vol. 15, 31 July 2003 (2003-07-31), pages 3496-3500, XP002453803, ISSN: 0897-4756, DOI: DOI:10.1021/CM030063R
- OHSHITA ET AL: "Synthesis of Polymers Composed of Alternative Diphenylenedithienosilole and Diethynylenesilyene Units and Their Applications to Hole Transport in Double-Layer El Devices", MACROMOLECULES,, vol. 33, 1 January 2000 (2000-01-01), pages 8890-8893, XP008110690, DOI: DOI:10.1021/MA0005062
- KUNAI A ET AL: "Synthesis and properties of silicon-bridged bithiophenes and application to EL devices", SYNTHETIC METALS, ELSEVIER SEQUOIA, LAUSANNE, CH, vol. 137, no. 1-3, 1 January 2003 (2003-01-01), pages 1007-1008, XP002480087, ISSN: 0379-6779, DOI: DOI:10.1016/S0379-6779(02)00854-8
- LIANG LIAO ET AL: "Photovoltaic Dithienosilole-Containing Polymers", MACROMOLECULES, AMERICAN CHEMICAL SOCIETY, US, vol. 40, 1 January 2007 (2007-01-01), pages 9406-9412, XP002543770, ISSN: 0024-9297, DOI: DOI:10.1021/MA071825X [retrieved on 2007-11-28]
- OHSHITA ET AL.: 'Synthesis of Polymers Composed of Alternative Diphenylenedithienosilole and Diethynylenesilyene Units and Their Applications to Hole Transport in Double-Layer El Devices' MACROMOLECULES vol. 33, 2000, pages 8890 - 8893, XP008110690

## Description

### TECHNICAL FIELD

This invention relates to photovoltaic cells with silole-containing polymers, as well as related components, systems, and methods.

### BACKGROUND

Photovoltaic cells are commonly used to transfer energy in the form of light into energy in the form of electricity. A typical photovoltaic cell includes a photoactive material disposed between two electrodes. Generally, light passes through one or both of the electrodes to interact with the photoactive material. As a result, the ability of one or both of the electrodes to transmit light (e.g., light at one or more wavelengths absorbed by a photoactive material) can limit the overall efficiency of a photovoltaic cell. In many photovoltaic cells, a film of semiconductive material (e.g., indium tin oxide) is used to form the electrode(s) through which light passes because, although the semiconductive material can have a lower electrical conductivity than electrically conductive materials, the semiconductive material can transmit more light than many electrically conductive materials.

M.S. Liu et al., Chem. Mater. 2003, 15, 3496-3500 disclose green-light-emitting diodes from silole-containing polymers, which are random copolymers based on poly(di-n-hexylfluorene-co-4,4-diphenyldithienosilole).

J. Ohshita et al., Macromolecules 2000, 33, 8890-8893 disclose the synthesis of polymers composed of alternating diphenylenedithienosilole and diethynylene-silylene units and their applications to hole transport in double-layer electroluminescent devices.

A. Kunai et al., Synthetic Metals 137 (2003), 1007-1008 disclose the synthesis of silicon-bridged bithiophenes and their application to electroluminescent devices.

L. Liao et al., Macromolecules 2007, 40, 9406-9412 disclose photovoltaic-active dithienosilole-containing polymers.

### SUMMARY

This invention relates to photovoltaic cells with silole-containing polymers (e.g., polymers containing a silacyclopentadithiophene moiety), as well as related components, systems, and methods.

An aspect of the invention relates to a new combination of monomers that produce polymers, wherein the polymers have properties suitable for use as charge carriers in the active layer of a photovoltaic cell.

This invention features a polymer including a first comonomer repeat unit and a second comonomer repeat unit different from the first comonomer repeat unit. The first comonomer repeat unit includes a silacyclopentadithiophene moiety of formula (1): 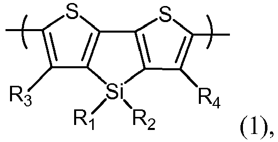 in which each of R₁, R₂, R₃, and R₄, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl. The second comonomer repeat unit includes a silacyclopentadithiophene moiety of formula (1), a benzothiadiazole moiety, a thiadiazoloquinoxaline moiety, a cyclopentadithiophene moiety, a cyclopentadithiophene oxide moiety, a benzoisothiazole moiety, a benzothiazole moiety, a thiophene oxide moiety, a thienothiophene moiety, a thienothiophene oxide moiety, a dithienothiophene moiety, a dithienothiophene oxide moiety, a tetrahydroisoindole moiety, a fluorenone moiety, a thiazole moiety, a selenophene moiety, a silole moiety, a thiazolothiazole moiety, a cyclopentadithiazole moiety, a naphthothiadiazole moiety, a thienopyrazine moiety, an oxazole moiety, an imidazole moiety, a pyrimidine moiety, a benzoxazole moiety, or a benzimidazole moiety.

In another aspect, this invention features a polymer including a first comonomer repeat unit and a second comonomer repeat unit different from the first comonomer repeat unit. The first comonomer repeat unit includes a silacyclopentadithiophene moiety of formula (1) set forth above. The second comonomer repeat unit includes a thiophene moiety substituted with C₁-C₂₀ alkyl, C₁-C₂₀ alkoxy, C₃-C₂₀ cycloalkyl, C₁-C₂₀ heterocycloalkyl, aryl, heteroaryl, halo, CN, OR', C(O)R', C(O)OR', or SO₂R'; or a thiophene moiety fused with a 1,4-dioxane moiety; R' being H, C₁-C₂₀ alkyl, C₁-C₂₀ alkoxy, aryl, heteroaryl, C₃-C₂₀ cycloalkyl, or C₁-C₂₀ heterocycloalkyl.

In another aspect, this invention features a polymer containing a first comonomer repeat unit and a second comonomer repeat unit different from the first comonomer repeat unit. The first comonomer repeat unit comprises a silacyclopentadithiophene moiety of formula (1) set forth above. The second comonomer repeat unit is not an unsubstituted thiophene moiety.

In still another aspect, this invention features an article that includes a first electrode, a second electrode, and a photoactive material disposed between the first and second electrodes. The photoactive material includes a polymer described above. The article is configured as a photovoltaic cell.

Embodiments can include one or more of the following features.

In some embodiments, R₁ and R₂, independently, is C₁-C₂₀ alkyl (e.g., hexyl).

In some embodiments, the second comonomer repeat unit includes a benzothiadiazole moiety of formula (2), a thiadiazoloquinoxaline moiety of formula (3), a cyclopentadithiophene dioxide moiety of formula (4), a cyclopentadithiophene monoxide moiety of formula (5), a benzoisothiazole moiety of formula (6), a benzothiazole moiety of formula (7), a thiophene dioxide moiety of formula (8), a cyclopentadithiophene dioxide moiety of formula (9), a cyclopentadithiophene tetraoxide moiety of formula (10), a thienothiophene moiety of formula (11), a thienothiophene tetraoxide moiety of formula (12), a dithienothiophene moiety of formula (13), a dithienothiophene dioxide moiety of formula (14), a dithienothiophene tetraoxide moiety of formula (15), a tetrahydroisoindole moiety of formula (16), a thienothiophene dioxide moiety of formula (17), a dithienothiophene dioxide moiety of formula (18), a silole moiety of formula (20), a cyclopentadithiophene moiety of formula (21), a fluorenone moiety of formula (22), a thiazole moiety of formula (23), a selenophene moiety of formula (24), a thiazolothiazole moiety of formula (25), a cyclopentadithiazole moiety of formula (26), a naphthothiadiazole moiety of formula (27), a thienopyrazine moiety of formula (28), an oxazole moiety of formula (29), an imidazole moiety of formula (30), a pyrimidine moiety of formula (31), a benzoxazole moiety of formula (32), or a benzimidazole moiety of formula (33):

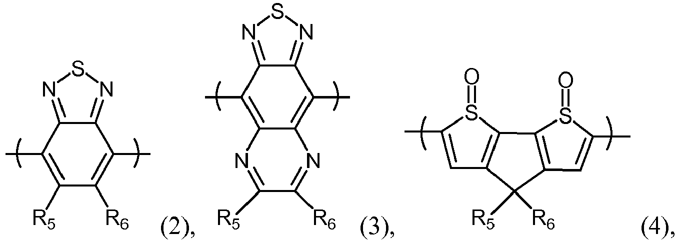

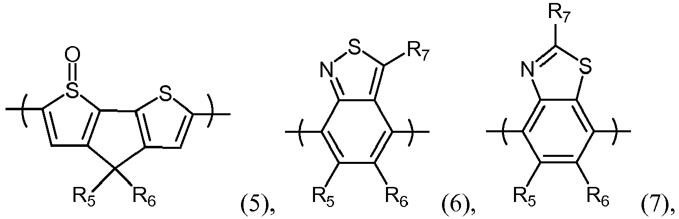

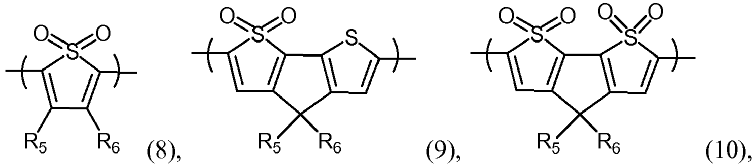

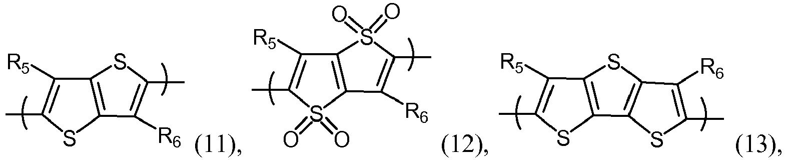

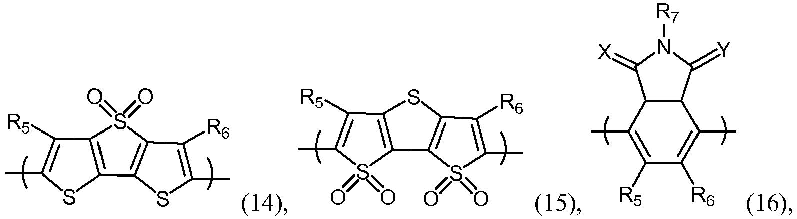

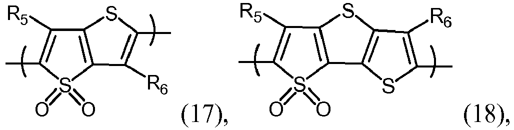

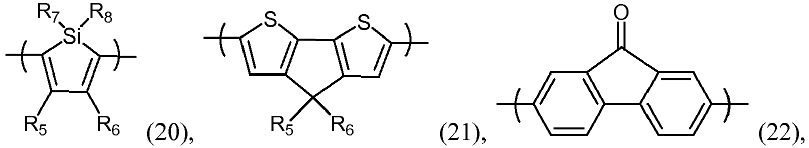

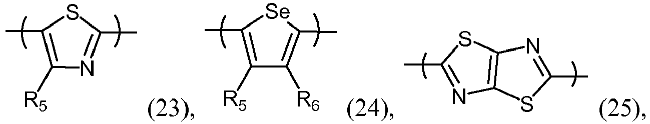

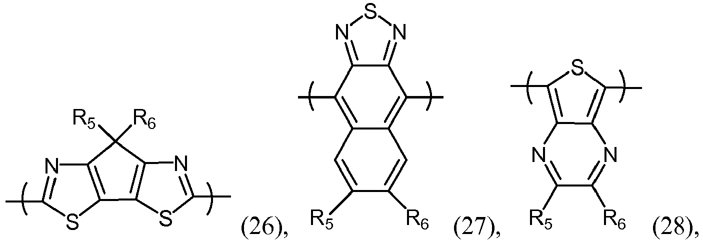

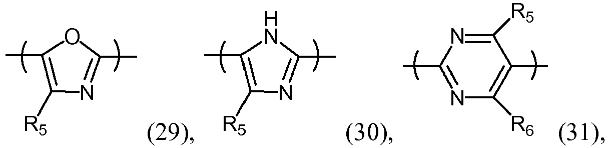

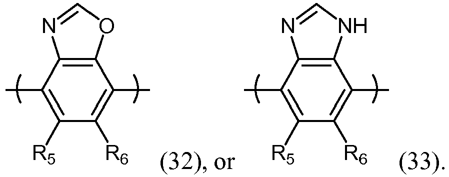

In formulas (2)-(33), each of X and Y, independently, is CH₂, O, or S; each of R₅ and R₆, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R, in which R is H, C₁-C₂₀ alkyl, C₁-C₂₀ alkoxy, aryl, heteroaryl, C₃-C₂₀ cycloalkyl, or C₁-C₂₀ heterocycloalkyl; and each of R₇ and R₈, independently, is H, C₁-C₂₀ alkyl, C₁-C₂₀ alkoxy, aryl, heteroaryl, C₃-C₂₀ cycloalkyl, or C₃-C₂₀ heterocycloalkyl.

In some embodiments, the second comonomer repeat unit includes a benzothiadiazole moiety of formula (2), in which each of R₅ and R₆ is H.

In some embodiments, the second comonomer repeat unit includes a thiazole moiety of formula (23), in which R₅ is hexyl.

In some embodiments, the polymer further includes a third comonomer repeat unit different from the first and second comonomer repeat units. The third comonomer repeat unit can include a thiophene moiety (e.g., a unsubstituted thiophene moiety or a thiophene moiety substituted with hexyl).

In some embodiments, the polymer can be either an electron donor material or an electron acceptor material.

In some embodiments, the polymer can be 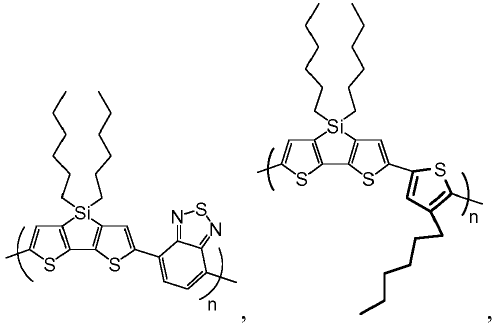 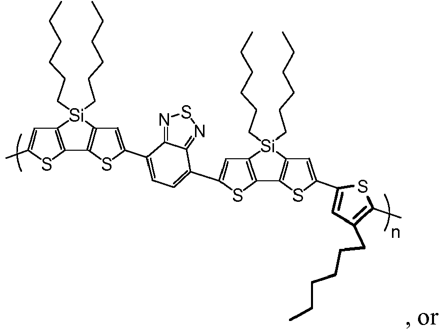 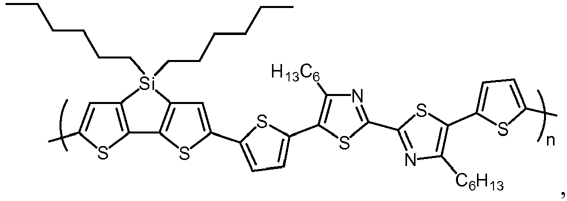 in which n can be an integer greater than 1.

In some embodiments, the photovoltaic cell can be a tandem photovoltaic cell.

In some embodiments, the photoactive material can include an electron acceptor material. In some embodiments, the electron acceptor material can be a fullerene (e.g., C61-phenyl-butyric acid methyl ester, PCBM).

In some embodiments, the polymer and the electron acceptor material each can have a LUMO energy level. The LUMO energy level of the polymer can be at least about 0.2 eV (e.g., at least about 0.3 eV) less negative than the LUMO energy level of the electron acceptor material.

In some embodiments, the device can be an organic semiconductive device. In certain embodiments, the device can be a member selected from the group consisting of field effect transistors, photodetectors, photovoltaic detectors, imaging devices, light emitting diodes, lasing devices, conversion layers, amplifiers and emitters, storage elements, and electrochromic devices.

Embodiments can provide one or more of the following advantages.

In some embodiments, using a polymer containing a silacyclopentadithiophene moiety can be advantageous because the silacyclopentadithiophene moiety can contribute to a shift in the maximum absorption wavelength toward the red or near IR region of the electromagnetic spectrum. When such a polymer is incorporated into a photovoltaic cell, the current and efficiency of the cell can increase.

In some embodiments, substituted fullerenes or polymers containing substituted monomer repeat units (e.g., substituted with long-chain alkoxy groups such as oligomeric ethylene oxides or fluorinated alkoxy groups) can have improved solubility in organic solvents and can form an photoactive layer with improved morphology.

In some embodiments, a polymer containing a silole moiety can absorb light at a relatively long wavelength and have improved solubility in organic solvents. In some embodiments, a polymer containing a silole moiety can be used to prepare an electron donor material with improved semiconductive properties.

In some embodiments, a photovoltaic cell containing a polymer described above can have a band gap that is relatively ideal for its intended purposes.

In some embodiments, a photovoltaic cell having high cell voltage can be created, whereby the HOMO level of the polymer is at least about 0.2 electron volts more negative relative to the LUMO or conduction band of an electron acceptor material.

In some embodiments, a photovoltaic cell containing a polymer described above can have relatively fast and efficient transfer of an electron to an electron acceptor material, whereby the LUMO of the donor is at least about 0.2 electron volt (e.g., at least about 0.3 electron volt) less negative than the conduction band of the electron acceptor material.

In some embodiments, a photovoltaic cell containing a polymer described above can have relatively fast charge separation, whereby the charge mobility of the positive charge, or hole, is relatively high and falls within the range of 10⁻⁴ to 10⁻¹ cm²/Vs.

In some embodiments, the polymer is soluble in an organic solvent and/or film forming.

In some embodiments, the polymer is optically non-scattering.

In some embodiments, the polymer can be used in organic field effect transistors and OLEDs.

Other features and advantages of the invention will be apparent from the description, drawings, and claims.

### DESCRIPTION OF DRAWINGS

FIG. 1 is a cross-sectional view of an embodiment of a photovoltaic cell.
FIG. 2 is a schematic of a system containing one electrode between two photoactive layers.

Like reference symbols in the various drawings indicate like elements.

### DETAILED DESCRIPTION

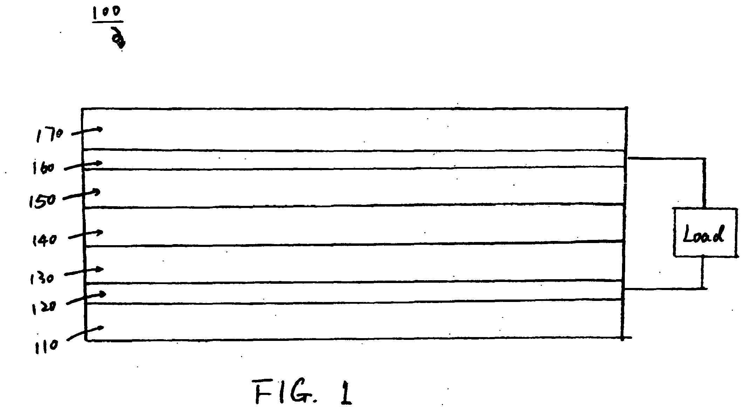

FIG. 1 shows a cross-sectional view of a photovoltaic cell 100 that includes a substrate 110, a cathode 120, a hole carrier layer 130, an active layer 140 (containing an electron acceptor material and an electron donor material), a hole blocking layer 150, an anode 160, and a substrate 170.

In general, during use, light impinges on the surface of substrate 110, and passes through substrate 110, cathode 120, and hole carrier layer 130. The light then interacts with active layer 140, causing electrons to be transferred from the electron donor material (e.g., a polymer described above) to the electron acceptor material (e.g., PCBM). The electron acceptor material then transmits the electrons through hole blocking layer 150 to anode 160, and the electron donor material transfers holes through hole carrier layer 130 to cathode 120. Anode 160 and cathode 120 are in electrical connection via an external load so that electrons pass from anode 160, through the load, and to cathode 120.

Electron acceptor materials of active layer 140 can include fullerenes. In some embodiments, active layer 140 can include one or more unsubstituted fullerenes and/or one or more substituted fullerenes. Examples of unsubstituted fullerenes include C₆₀, C₇₀, C₇₆, C₇₈, C₈₂, C₈₄, and C₉₂. Examples of substituted fullerenes include PCBM or fullerenes substituted with C₁-C₂₀ alkoxy optionally further substituted with C₁-C₂₀ alkoxy or halo (e.g., (OCH₂CH₂)₂OCH₃ or OCH₂CF₂OCF₂CF₂OCF₃). Without wishing to be bound by theory, it is believed that fullerenes substituted with long-chain alkoxy groups (e.g., oligomeric ethylene oxides) or fluorinated alkoxy groups have improved solubility in organic solvents and can form an photoactive layer with improved morphology.

In some embodiments, the electron acceptor materials can include polymers (e.g., homopolymers or copolymers). A polymers mentioned herein include at least two identical or different monomer repeat units (e.g., at least 5 monomer repeat units, at least 10 monomer repeat units, at least 50 monomer repeat units, at least 100 monomer repeat units, or at least 500 monomer repeat units). A copolymer mentioned herein refers to a polymer that includes at least two co-monomers of differing structures. In some embodiments, the polymers used as an electron acceptor material can include one or more monomer repeat units listed in Tables 1 and 2 below. Specifically, Table 1 lists examples of electron donating monomer repeat units that can serve as a conjugative link. Table 2 lists examples of electron withdrawing monomer repeat units. Note that depending on the substituents, monomer repeat units listed in Table 1 can be electron withdrawing and monomer repeat units listed in Table 2 can also be electron donating. Preferably, the polymers used as an electron acceptor material include a high molar percentage (e.g., at least about 50%, at least about 60%, at least about 70%, at least about 80%, at least about 90%) of an electron withdrawing monomer repeat unit.

Electron donor materials of active layer 140 can include polymers (e.g., homopolymers or copolymers). In some embodiments, the polymers used as an electron donor material can include one or more monomer repeat units listed in Tables 1 and 2. Preferably, the polymers used as an electron donor material include a high molar percentage (e.g., at least about 50%, at least about 60%, at least about 70%, at least about 80%, at least about 90%) of an electron donating monomer repeat unit. In some embodiments, the polymers include a monomer repeat unit containing C₁-C₂₀ alkoxy on a ring, which is optionally further substituted with C₁-C₂₀ alkoxy or halo (e.g., (OCH₂CH₂)₂OCH₃ or OCH₂CF₂OCF₂CF₂OCF₃). Without wishing to be bound by theory, it is believed that polymers containing monomer repeat units substituted with long-chain alkoxy groups (e.g., oligomeric ethylene oxides) or fluorinated alkoxy groups have improved solubility in organic solvents and can form an photoactive layer with improved morphology.

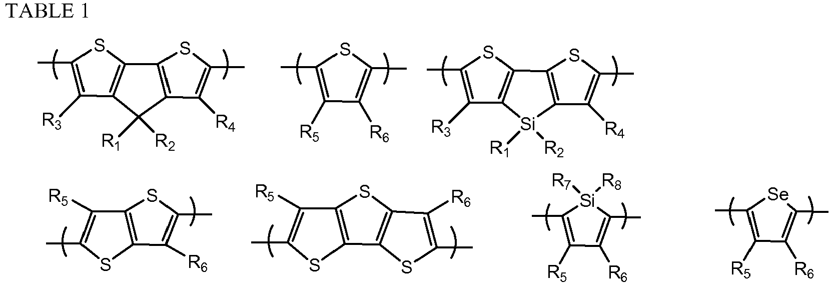

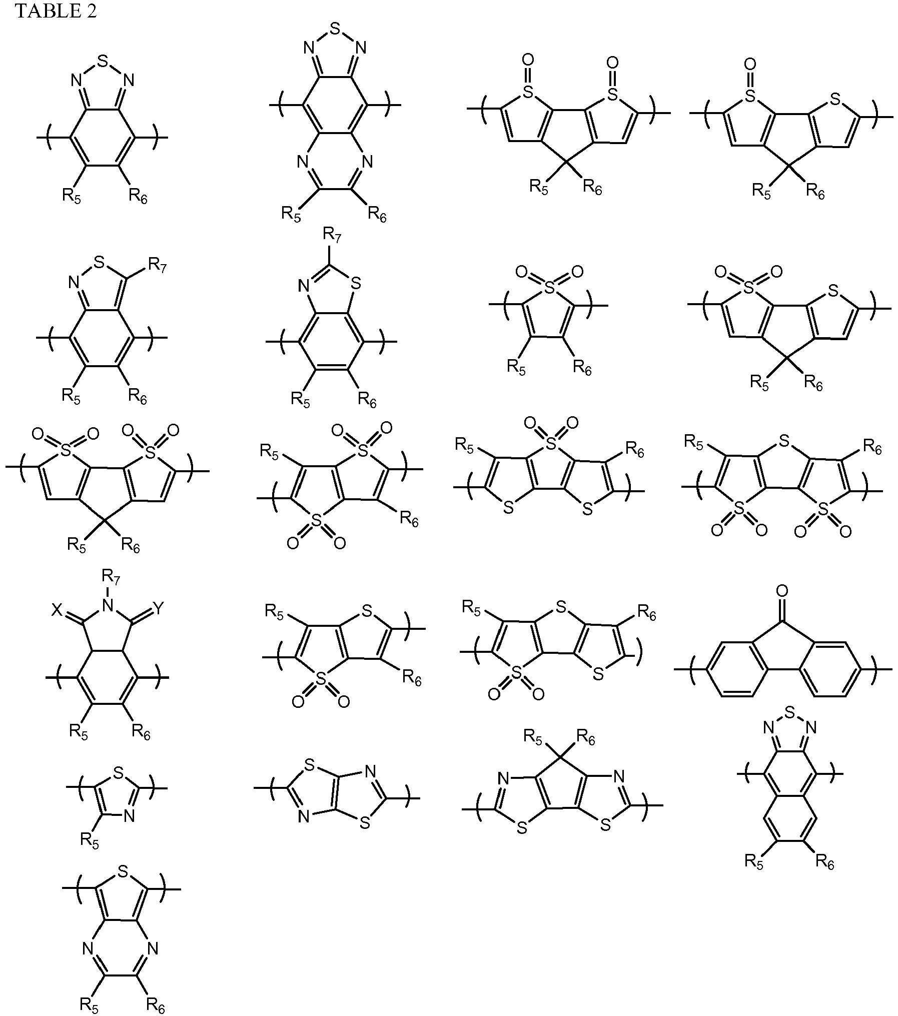

Referring to formulas listed in Tables 1 and 2 above, each of X and Y, independently, can be CH₂, O, or S; each of R₁, R₂, R₃, R₄, R₅, and R₆, independently, can be H, C₁-C₂₀ alkyl (e.g., branched alkyl or perflorinated alkyl), C₁-C₂₀ alkoxy, C₃-C₂₀ cycloalkyl, C₁-C₂₀ heterocycloalkyl, aryl (e.g., phenyl or substituted phenyl), heteroaryl, halo, CN, OR, C(O)R, C(O)OR, or SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl; and each of R₇ and R₈, independently, is H, C₁-C₂₀ alkyl, C₁-C₂₀ alkoxy, aryl, heteroaryl, C₃-C₂₀ cycloalkyl, or C₃-C₂₀ heterocycloalkyl.

An alkyl can be saturated or unsaturated and branch or straight chained. A C₁-C₂₀ alkyl contains 1 to 20 carbon atoms (e.g., one, two, three, four, five, six, seven, eight, nine, 10, 11, 12, 13, 14, 15, 16, 17, 18, 19, and 20 carbon atoms). Examples of alkyl moieties include -CH₃, -CH₂-, -CH₂=CH₂-, -CH₂-CH=CH₂, and branched -C₃H₇. An alkoxy can be branch or straight chained and saturated or unsaturated. An C₁-C₂₀ alkoxy contains an oxygen radical and 1 to 20 carbon atoms (e.g., one, two, three, four, five, six, seven, eight, nine, 10, 11, 12, 13, 14, 15, 16, 17, 18, 19, and 20 carbon atoms). Examples of alkoxy moieties include -OCH₃ and -OCH=CH-CH₃. A cycloalkyl can be either saturated or unsaturated. A C₃-C₂₀ cycloalkyl contains 3 to 20 carbon atoms (e.g., three, four, five, six, seven, eight, nine, 10, 11, 12, 13, 14, 15, 16, 17, 18, 19, and 20 carbon atoms). Examples of cycloalkyl moieities include cyclohexyl and cyclohexen-3-yl. A heterocycloalkyl can also be either saturated or unsaturated. A C₃-C₂₀ heterocycloalkyl contains at least one ring heteroatom (e.g., O, N, and S) and 3 to 20 carbon atoms (e.g., three, four, five, six, seven, eight, nine, 10, 11, 12, 13, 14, 15, 16, 17, 18, 19, and 20 carbon atoms). Examples of heterocycloalkyl moieties include 4-tetrahydropyranyl and 4-pyranyl. An aryl can contain one or more aromatic rings. Examples of aryl moieties include phenyl, phenylene, naphthyl, naphthylene, pyrenyl, anthryl, and phenanthryl. A heteroaryl can contain one or more aromatic rings, at least one of which contains at least one ring heteroatom (e.g., O, N, and S). Examples of heteroaryl moieties include furyl, furylene, fluorenyl, pyrrolyl, thienyl, oxazolyl, imidazolyl, thiazolyl, pyridyl, pyrimidinyl, quinazolinyl, quinolyl, isoquinolyl, and indolyl.

Alkyl, alkoxy, cycloalkyl, heterocycloalkyl, aryl, and heteroaryl mentioned herein include both substituted and unsubstituted moieties, unless specified otherwise. Examples of substituents on cycloalkyl, heterocycloalkyl, aryl, and heteroaryl include C₁-C₂₀ alkyl, C₃-C₂₀ cycloalkyl, C₁-C₂₀ alkoxy, aryl, aryloxy, heteroaryl, heteroaryloxy, amino, C₁-C₁₀ alkylamino, C₁-C₂₀ dialkylamino, arylamino, diarylamino, hydroxyl, halogen, thio, C₁-C₁₀ alkylthio, arylthio, C₁-C₁₀ alkylsulfonyl, arylsulfonyl, cyano, nitro, acyl, acyloxy, carboxyl, and carboxylic ester. Examples of substituents on alkyl include all of the above-recited substituents except C₁-C₂₀ alkyl. Cycloalkyl, heterocycloalkyl, aryl, and heteroaryl also include fused groups.

The monomers for preparing the polymers mentioned herein may contain a non-aromatic double bond and one or more asymmetric centers. Thus, they can occur as racemates and racemic mixtures, single enantiomers, individual diastereomers, diastereomeric mixtures, and cis- or trans- isomeric forms. All such isomeric forms are contemplated.

The copolymers described above can be prepared by methods known in the art. For example, a copolymer can be prepared by a cross-coupling reaction between one or more comonomers containing two alkylstannyl groups and one or more comonomers containing two halo groups in the presence of a transition metal catalyst. As another example, a copolymer can be prepared by a cross-coupling reaction between one or more comonomers containing two borate groups and one or more comonomers containing two halo groups in the presence of a transition metal catalyst. The comonomers can be prepared by the methods described herein or by the methods know in the art, such as those described in U.S. Patent Application Serial No. 11/486,536, Coppo et al., Macromolecules 2003, 36, 2705-2711 and Kurt et al., J. Heterocycl. Chem. 1970, 6, 629

Table 3 below lists four exemplary polymers (i.e., polymers 1-4) described in the Summary section above. These polymers can have unique properties, which make them particularly suitable as charge carriers in the active layer of a photovoltaic cell. Polymers 1-4 can be obtained by the methods described in Examples 2-5 below.

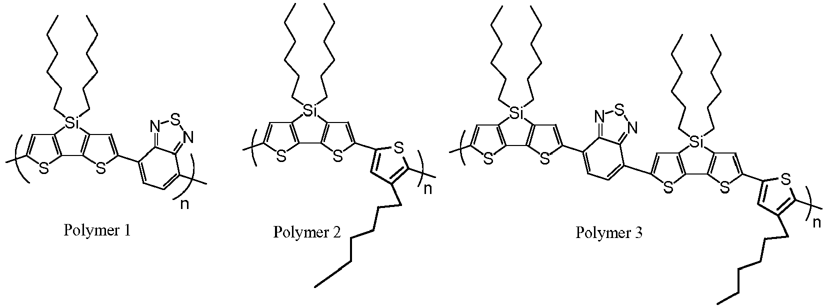

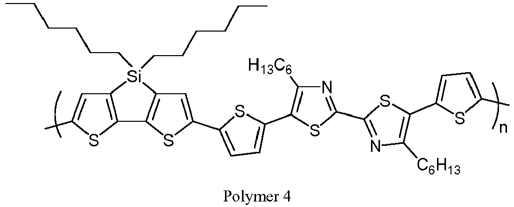

Generally, one co-monomer in the polymers described in the Summary section above is a silacyclopentadithiophene. An advantage of a co-polymer containing a silacyclopentadithiophene moiety is that its absorption wavelength can shift toward the red and near IR portion (e.g., 650 - 800 nm) of the electromagnetic spectrum, which is not accessible by most other polymers. When such a co-polymer is incorporated into a photovoltaic cell, it enables the cell to absorb the light in this region of the spectrum, thereby increasing the current and efficiency of the cell.

The polymers described above can be useful in solar power technology because the band gap is close to ideal for a photovoltaic cell (e.g., a polymer-fullerene cell). The HOMO level of the polymers can be positioned correctly relative to the LUMO of an electron acceptor (e.g., PCBM) in a photovoltaic cell (e.g., a polymer-fullerene cell), allowing for high cell voltage. The LUMO of the polymers can be positioned correctly relative to the conduction band of the electron acceptor in a photovoltaic cell, thereby creating efficient transfer of an electron to the electron acceptor. For example, using a polymer having a band gap of about 1.4 - 1.6 eV can significantly enhance cell voltage. Cell performance, specifically efficiency, cam benefit from both an increase in photocurrent and an increase in cell voltage, and can approach and even exceed 15 % efficiency. The positive charge mobility of the polymers can be relatively high and approximately in the range of 10⁻⁴ to 10⁻¹ cm²/Vs. In general, the relatively high positive charge mobility allows for relatively fast charge separation. The polymers can also be soluble in an organic solvent and/or film forming. Further, the polymers can be optically non-scattering.

Components in photovoltaic cell other than the electron acceptor materials and the electron donor materials are known in the art, such as those described in U.S. Patent Application Serial No. 10/723,554.

In some embodiments, the polymer described above can be used as an electron donor material or an electro acceptor material in a system in which two photovoltaic cells share a common electrode. Such a system is also known as tandem photovoltaic cell. Examples of tandem photovoltaic cells are discussed in U.S. Patent Application Serial No. 10/558,878, filed November 29, 2005.

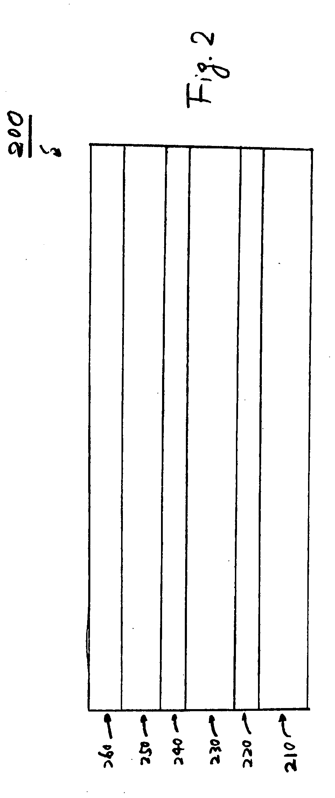

As an example, FIG. 2 is a schematic of a tandem photovoltaic cell 200 having a substrate 210, three electrodes 220, 240, and 260, and two photoactive layers 230 and 250. Electrode 240 is shared between photoactive layers 230 and 250, and is electrically connected with electrodes 220 and 260. In general, electrodes 220, 240, and 260 can be formed of an electrically conductive material, such as those described in U.S. Patent Application Serial No. 10/723,554. In some embodiments, one or more (i.e., one, two, or three) electrodes 220, 240, and 260 is a mesh electrode. In some embodiments, one or more electrodes 220, 240, and 260 is formed of a semiconductive material. Examples of semiconductive materials include titanium oxides, indium tin oxides, fluorinated tin oxides, tin oxides, and zinc oxides. In certain embodiments, one or more (i.e., one, two, or three) electrodes 220, 240, and 260 are formed of titanium dioxide. Titanium dioxide used to prepare an electrode can be in any suitable forms. For example, titanium dioxide can be in the form of interconnected nanoparticles. Examples of interconnected titanium dioxide nanoparticles are described, for example, in U.S. Patent 7,022,910. In some embodiments, at least one (e.g., one, two, or three) of electrodes 220, 240, and 260 is a transparent electrode. As referred to herein, a transparent electrode is formed of a material which, at the thickness used in a photovoltaic cell, transmits at least about 60% (e.g., at least about 70%, at least about 75%, at least about 80%, at least about 85%, at least about 90%, at least about 95%) of incident light at a wavelength or a range of wavelengths used during operation of the photovoltaic cell. In certain embodiments, both electrodes 220 and 260 are transparent electrodes.

Each of photoactive layers 230 and 250 can contain at least one semiconductive material. In some embodiments, the semiconductive material in photoactive layer 230 has the same band gap as the semiconductive material in photoactive layer 250. In certain embodiments, the semiconductive material in photoactive layer 230 has a band gap different from that of the semiconductive material in photoactive layer 250. Without wishing to be bound by theory, it is believed that incident light not absorbed by one photoactive layer can be absorbed by the other photoactive layer, thereby maximizing the absorption of the incident light.

In some embodiments, at least one of photoactive layers 230 and 250 can contain an electron acceptor material (e.g., PCBM or a polymer described above) and an electron donor material (e.g., a polymer described above). In general, suitable electron acceptor materials and electron donor materials can be those described above. In certain embodiments, each of photoactive layers 230 and 250 contains an electron acceptor material and an electron donor material.

Substrate 210 can be formed of one or more suitable polymers, such as those described in U.S. Patent Application Serial No. 10/723,554. In some embodiments, an additional substrate (not shown in FIG. 2) can be disposed on electrode 260.

Photovoltaic cell 200 can further contain a hole carrier layer (not shown in FIG. 2) and a hole blocking layer (not shown in FIG. 2), such as those described in U.S. Patent Application Serial No. 10/723,554.

While photovoltaic cells have been described above, in some embodiments, the polymers described herein can be used in other devices and systems. For example, the polymers can be used in suitable organic semiconductive devices, such as field effect transistors, photodetectors (e.g., IR detectors), photovoltaic detectors, imaging devices (e.g., RGB imaging devices for cameras or medical imaging systems), light emitting diodes (LEDs) (e.g., organic LEDs or IR or near IR LEDs), lasing devices, conversion layers (e.g., layers that convert visible emission into IR emission), amplifiers and emitters for telecommunication (e.g., dopants for fibers), storage elements (e.g., holographic storage elements), and electrochromic devices (e.g., electrochromic displays).

The following examples are illustrative and not intended to be limiting.

### Example 1: Synthesis of bis-(5,5'-trimethylstannyl)-3,3'-di-n-hexyl-silylene-2,2'-dithiophene

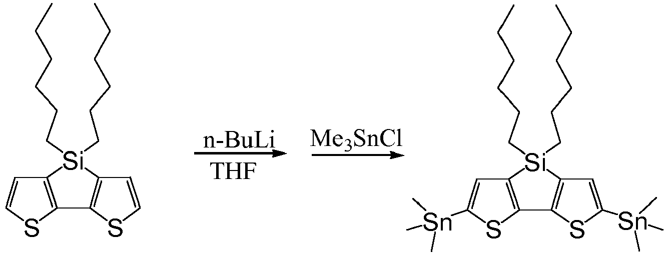

0.638 g (1.76 mmol) of 3,3'-di-n-hexylsilylene-2,2'-dithiophene (prepared according to the procedures described in Usta et al., J. Am. Chem. Soc., 2006; 128(28); 9034-9035) was dissolved in 20 mL of freshly distilled dry THF. The solution was purged with nitrogen for 15 minutes and cooled to -78°C. 4.00 mL of n-butyl lithium in hexane (10 mmol) was added to this solution dropwise. The solution was allowed to react for two hours at this temperature. Te solution was then warmed to room temperature and allowed to react for additional two and half hours. After the solution was subsequently cooled down to -78°C, 12.00 ml (12.00 mmol) of trimethyltin chloride in hexane was added into the solution dropwise. The reaction solution was stirred at -78°C for two more hours. The solution was then warmed to room temperature and allowed to react for 16 more hours. Upon the completion of reaction, 100 ml of distilled water was added and the solution was extracted using toluene (3 x 60 ml). The combined organic phase was washed with distilled water (3 x 150 ml) and dried over sodium sulfate. The organic solvent was removed via rotary evaporation under vacuum. The residue was dissolved in toluene and quickly passed through a silica-gel pad pretreated with triethyl amine. The organic solvent was removed under vacuum to give the title compound (1.048 g). The yield was about 86.50%. ¹H NMR in CDCl₃: 7.00 (m, 2H), 1.25-1.42 (m, 16H), 0.86-0.94 (m, 10H), and 0.38 (m, 18H).

### Example 2: Polymerization of bis-(5,5'-trimethylstannyl)-3,3'-di-n-hexyl-silylene-2,2'-dithiophene and 4,7-dibromo-2,13-benzothiadiazole

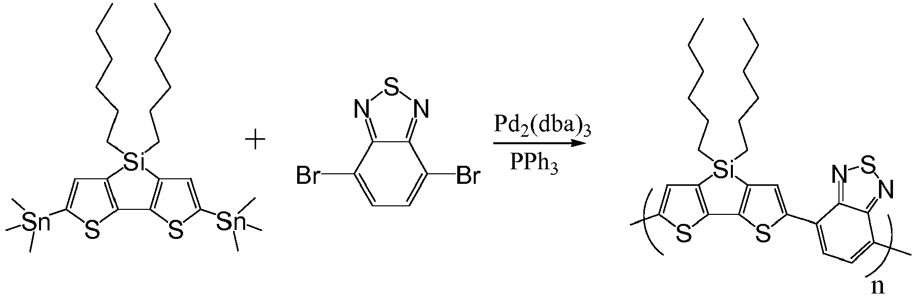

0.353 g (0.513 mmol) of bis-(5,5'-trimethylstannyl)-3,3'-di-n-hexyl-silylene-2,2'-dithiophene and 0.135 g (0.500 mmol) (monomer ratio = 1.025) of 4,7-dibromo-2,1,3-benzothiadiazole were dissolved in 12 mL of anhydrous toluene. After the solution was purged with nitrogen, 12.55 mg (0.014 mmol) of tris(dibenzylideneacetone)dipalladium (0) and 28.80 mg (0.110 mmol) of triphenylphosphine were added. The solution was further purged with nitrogen for 15 minutes. The solution was then heated up to 110-120°C and allowed to react for 40 hours. Upon the completion of the reaction, the solvent was removed via rotary evaporation. The resultant residue was dissolved in about 30 mL of chlorobenzene. After the chlorobenzene solution was poured into 600 mL of methanol, a deep blue precipitate thus obtained (the crude polymer product) was collected through filtration. The collected solid was redissolved in about 40 mL of chlorobenzene during heating. The chlorobenzene solution was filtered through a 0.45 µ membrane, and poured into 600 mL of methanol. After the dark blue color polymer product thus obtained was collected through filtration, it was washed with methanol (3 x 100 ml) and dried under vacuum.

The dried polymer product was redissolved in 60 ml of hot chlorobenzene and poured into 60 mL of 7.5% sodium diethyldithiocarbamate trihydrate (DDC) aqueous solution. The solution was purged by nitrogen for 15 minutes. The mixed two phase solution thus obtained was heated at about 80°C and stirred vigorously under nitrogen for 15 hours. After the organic phase was washed with hot distilled water (3 x 60 ml), it was slowly poured into 800 mL of methanol. The precipitate was collected through filtration. The collected polymer product was first extracted with acetone and methanol each for 12 hours through Soxhlet extraction apparatus. The polymer product was then collected and dried. The molecular weight distribution of the polymer product was analyzed using HPLC through a GPC column with polystyrene as a reference (HPLC Instrument: Agilent Technologies., Model No. 1090M. HPLC Column: PL Gel 10M Mixed B. Solvent used: Chlorobenzene). The measured molecular weight distributions are: Mₙ = 4,000 and M_{w} = 5,000. λ_{max.} (nm) (in chlorobenzene) = 641 nm. λ_{max.} (nm) (thin film) = 673 nm.

HOMO (eV) = -5.47 (from electrochemical measurement), LUMO (eV) = - 3.69 (from electrochemical measurement), and 1.78 eV for the value of band gap (calculated from electrochemical measurement results).

### Example 3: Polymerization of bis-(5,5'-trimethylstannyl)-3,3'-di-n-hexyl-silylene-2,2'-dithiophene and 3-hexyl-2, 5-dibromo-thiophene

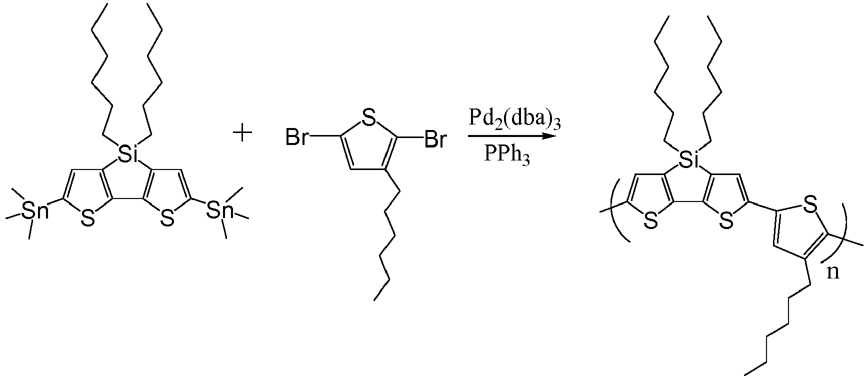

0.353 g (0.513 mmol) of bis-(5,5'-trimethylstannyl)-3,3'-di-n-hexyl-silylene-2,2'-dithiophene and 0.163 g (0.500 mmol) (monomer ratio = 1.025) of 3-hexyl-2,5-dibromothiophene were dissolved in 12 mL of anhydrous toluene. After the solution was purged with nitrogen, 12.55 mg (0.014 mmol) of tris (dibenzylideneacetone) dipalladium (0) and 28.80 mg (0.110 mmol) of triphenylphosphine were added. The solution was further purged with nitrogen for 15 minutes. The solution was then heated up to 110-120°C and allowed to react for 40 hours. Upon the completion of the reaction, the solvent was removed via rotary evaporation. The resultant residue was washed with methanol (50 mL x 3), and then washed with of acetone (3 x 50 ml). The residue of the polymer product was collected as dark red-purple solid. The collected polymer product was redissolved in about 60 mL of chloroform under heating. After the chloroform solution was filtered through a 0.45 µ membrane, the solvent was removed via rotary evaporation under vacuum. The polymer product was then dried under vacuum.

The dried polymer product was redissolved in 60 ml of hot toluene. The solution was poured into 60 mL of 7.5% DDC aqueous solution. The solution was purged by nitrogen for 15 minutes. The mixed two phase solution thus obtained was heated at about 80°C and stirred vigorously under nitrogen protection for 12 hours. After the organic phase was then washed with hot distilled water (3 x 60 ml), the organic phase was collected and dried over anhydrous magnesium sulfate. The solvent was removed to give a solid polymer product. The solid polymer product was sequentially extracted with methanol and acetone for 12 hours each through Soxhlet extraction apparatus. Finally, the polymer product was collected and dried. The molecular weight distribution of the polymer was analyzed using HPLC through a GPC column with polystyrene as a reference (HPLC Instrument: Agilent Technologies, Model No. 1090M. HPLC Column: PL Gel 10M Mixed B. Solvent used: Chlorobenzene). The measured molecular weight distributions are: Mₙ = 10,000 and M_{w} = 13,500. λ_{max.} (nm) (in chlorobenzene) = 501 nm. λ_{max.} (nm) (thin film) = 503 nm.

### Example 4: Polymerization of bis-(5,5'-trimethylstannyl)-3,3'-di-n-hexyl-silylene-2,2'-dithiophene, 4,7-dibromo-2,13-benzothiadiazole, and 3-hexyl-2, 5-dibromo-thiophene

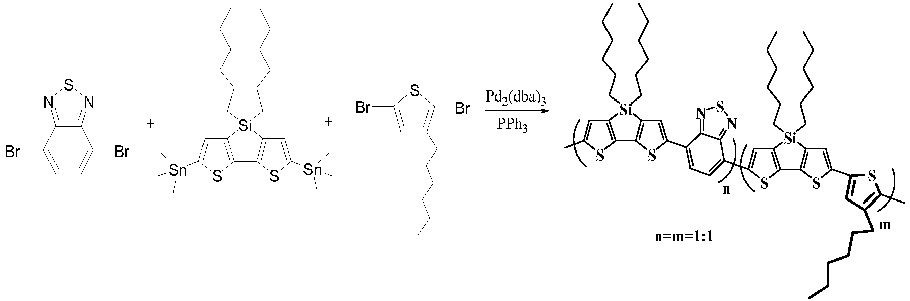

0.310 g (0.450 mmol) of bis-(5,5'-trimethylstannyl)-3,3'-di-n-hexyl-silylene-2,2'-dithiophene, 0.068 g (0.225 mmol) (monomer ratio = 1.025) of 4,7-dibromo-2,1,3-benzothiadiazole, and 0.073 g (0.225 mmol) of 3-hexyl-2,5-dibromothiophene (monomer ratio = 2:1:1) were dissolved in 12 mL of anhydrous toluene. After the solution was purged with nitrogen, 12.55 mg (0.014 mmol) of tris(dibenzylideneacetone)dipalladium (0) and 28.80 mg (0.110 mmol) of triphenylphosphine were added. The solution was further purged with nitrogen for 15 minutes. The solution was then heated up to 110-120°C and allowed to react for 40 hours. Upon the completion of the reaction, the solvent was removed via rotary evaporation. The resultant residue was dissolved in about 30 mL of chlorobenzene. After the solution was poured into 600 mL of methanol, deep blue-black precipitate was collected through filtration. The collected solid polymer product was then redissolved in about 40 mL of chlorobenzene under heating. After the chlorobenzene solution was filtered through a 0.45 µ membrane, it was poured into 600 mL of methanol. The dark blue-black color polymer product was collected again through filtration. The solid polymer product was washed with methanol (3 x 100 ml) and dried under vacuum.

The dried polymer product was redissolved in 60 ml of hot chlorobenzene and poured into 60 mL of 7.5% DDC aqueous solution. The solution was purged by nitrogen for 15 minutes. The mixed two phase solution thus obtained was heated at about 80°C and stirred vigorously under nitrogen protection for 15 hours. The organic phase was then washed by hot distilled water (3 x 60 ml). After the chlorobenzene solution was slowly poured into 800 ml of methanol, the precipitate thus obtained was collected through filtration. The collected solid polymer product was sequentially extracted with acetone and methanol for 12 hours each through Soxhlet extraction apparatus. The polymer product was then collected and dried. The molecular weight distribution of the polymer was analyzed using HPLC through a GPC column with polystyrene as a reference (HPLC Instrument: Agilent Technologies, Model No. 1090M. HPLC Column: PL Gel 10M Mixed B. Solvent used: Chlorobenzene). The measured molecular weight distributions are: Mₙ = 7,500 and M_{w} = 10,400. λ_{max.} (nm) (in chlorobenzene) = 595 nm. λ_{max.} (nm) (thin film) = 649 nm.

### Example 5: Polymerization of bis-(5,5'-trimethylstannyl)-3,3'-di-n-hexyl-silylene-2,2'-dithiophene and 5,5'-bis(5-bromo-2-thienyl)-4,4'-dihexyl-2,2'-bithiazole

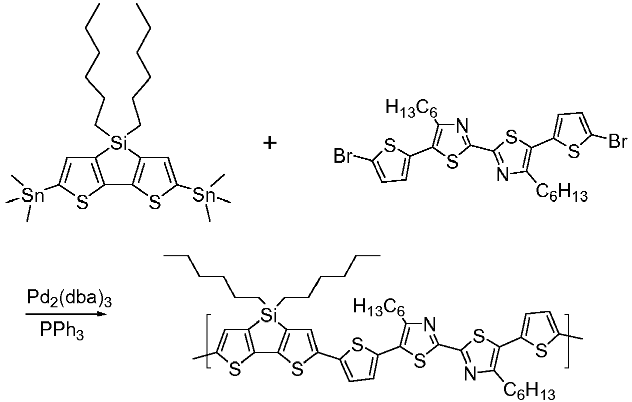

A 100 mL Schlenk flask was charged with 0.045 g (0.0654 mmol) of bis-(5,5'-trimethylstannyl)-3,3'-di-n-hexyl-silylene-2,2'-dithiophene, 0.043 g (0.0654 mmol) of 5,5'-bis(5-bromo-2-thienyl)-4,4'-dihexyl-2,2'-bithiazole, 1.0 mg (0.00109 mmol) of Pd₂dba₃, and 2.0 mg (0.0076 mmol) of PPh₃. The flask was evacuated and refilled with argon three times. The solids were dissolved in 3 mL of o-xylene and the solution was heated to 95°C for 24 hours. The solution was then cooled, poured into 500 mL of stirring MeOH, and filtered. The dark precipitate thus obtained was washed with MeOH, dried under vacuum to give a brown solid (0.069 g). Mn = 3.7 kDa. Mw = 4.6 kDa.

### Example 6: Fabrication of solar cell

Polymers 1 and 2 were used to fabricate solar cells on glass/ITO substrates as follows: A PEDOT (Baytron PH) layer, used as electron blocker, was obtained by doctor-blading an isopropanol solution on the ITO. The PEDOT layer was successively hard-baked to improve its resistance to solvents. An active layer, a mixture of a test polymer (i.e., Polymer 1 or 2) and PCBM in weight ratio 1:1 in CHCl₃ or o-dichlorobenzene was then applied on top of the PEDOT layer. The device was completed by applying a top electrode by high-vacuum evaporation of a bilayer of LiF/Aluminum. The current density-voltage (J-V) characteristics of the devices were assessed with a Keithley SMU 2400 source measurement unit under a nitrogen atmosphere. Filtered xenon lamp light from an Oriel solar simulator was used to approximate the AM 1.5G spectrum at 0.1 W/cm². The results show that the film formed by polymer 1 or 2 contains pinholes and that the solar cell containing polymer 1 or 2 has an efficiency of 0.7% or less.

Other embodiments are in the claims.

## Claims

1. An article (100; 200), comprising:
a first electrode (120; 220; 240);
a second electrode (160; 240; 260); and
a photoactive material (140; 230; 350) disposed between the first (120; 220; 240) and second electrodes (160; 240; 260), the photoactive material (140; 230; 350) comprising a polymer including a first comonomer repeat unit and a second comonomer repeat unit different from the first comonomer repeat unit;
**characterized in that**
the first comonomer repeat unit comprises a silacyclopentadithiophene moiety of formula (1): 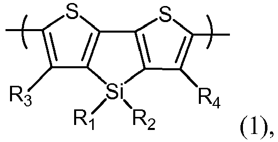 in which each of R₁, R₂, R₃, and R₄, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl;
the second comonomer repeat unit comprises a silacyclopentadithiophene moiety of formula (I), a benzothiadiazole moiety, a thiadiazoloquinoxaline moiety, a cyclopentadithiophene moiety, a cyclopentadithiophene oxide moiety, a benzoisothiazole moiety, a benzothiazole moiety, a thiophene oxide moiety, a thienothiophene moiety, a thienothiophene oxide moiety, a dithienothiophene moiety, a dithienothiophene oxide moiety, a tetrahydroisoindole moiety, a fluorenone moiety, a thiazole moiety, a selenophene moiety, a silole moiety, a thiazolothiazole moiety, a cyclopentadithiazole moiety, a naphthothiadiazole moiety, a thienopyrazine moiety, an oxazole moiety, an imidazole moiety, a pyrimidine moiety, a benzoxazole moiety, or a benzimidazole moiety; and
the article is configured as a photovoltaic cell.

2. The article of claim 1, wherein each of R₁ and R₂, independently, is C₁-C₂₀ alkyl.

3. The article of claim 1, wherein each of R₁ and R₂ is hexyl.

4. The article of claim 1, wherein the second comonomer repeat unit comprises a benzothiadiazole moiety of formula (2), a thiadiazoloquinoxaline moiety of formula (3), a cyclopentadithiophene dioxide moiety of formula (4), a cyclopentadithiophene monoxide moiety of formula (5), a benzoisothiazole moiety of formula (6), a benzothiazole moiety of formula (7), a thiophene dioxide moiety of formula (8), a cyclopentadithiophene dioxide moiety of formula (9), a cyclopentadithiophene tetraoxide moiety of formula (10), a thienothiophene moiety of formula (11), a thienothiophene tetraoxide moiety of formula (12), a dithienothiophene moiety of formula (13), a dithienothiophene dioxide moiety of formula (14), a dithienothiophene tetraoxide moiety of formula (15), a tetrahydroisoindole moiety of formula (16), a thienothiophene dioxide moiety of formula (17), a dithienothiophene dioxide moiety of formula (18), a silole moiety of formula (20), a cyclopentadithiophene moiety of formula (21), a fluorenone moiety of formula (22), a thiazole moiety of formula (23), a selenophene moiety of formula (24), a thiazolothiazole moiety of formula (25), a cyclopentadithiazole moiety of formula (26), a naphthothiadiazole moiety of formula (27), a thienopyrazine moiety of formula (28), an oxazole moiety of formula (29), an imidazole moiety of formula (30), a pyrimidine moiety of formula (31), a benzoxazole moiety of formula (32), or a benzimidazole moiety of formula (33): 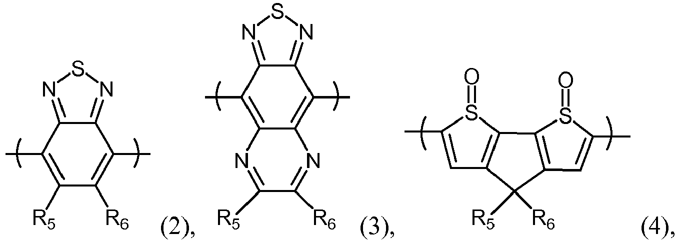 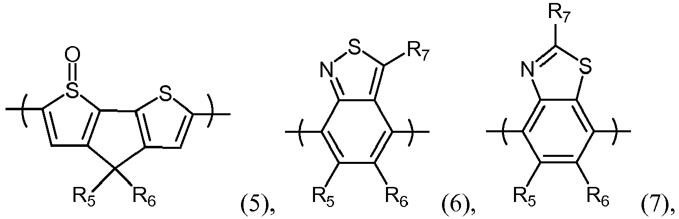 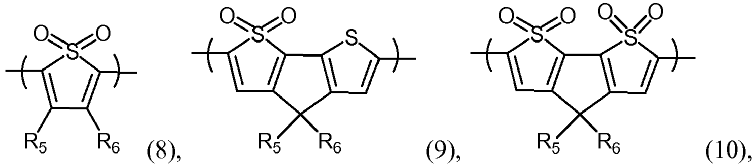 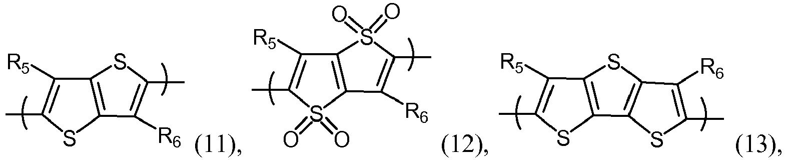 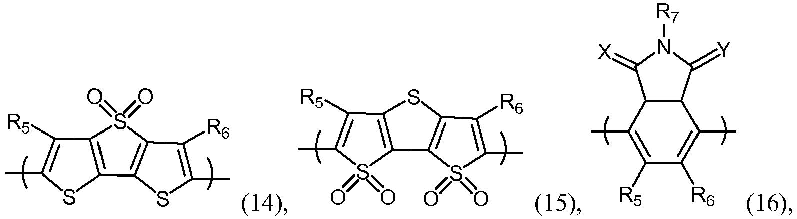 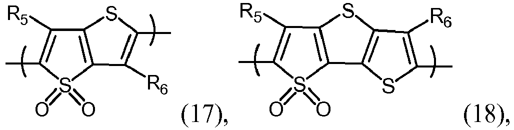 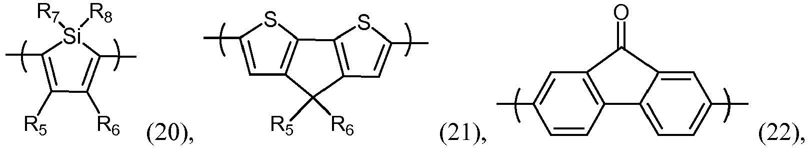 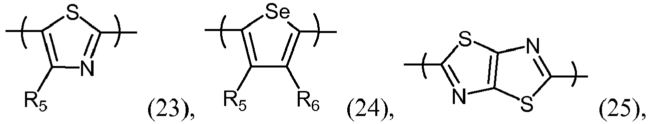 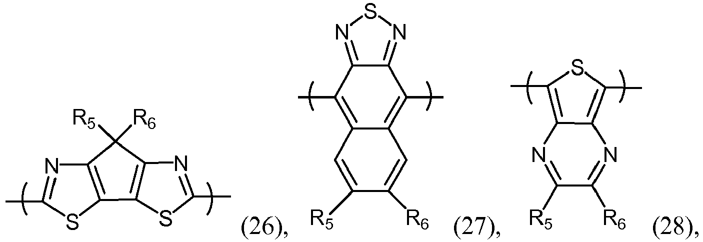 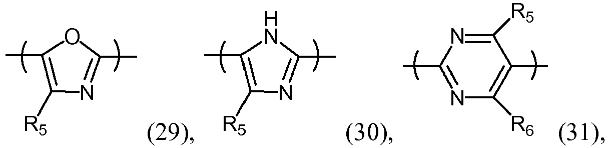 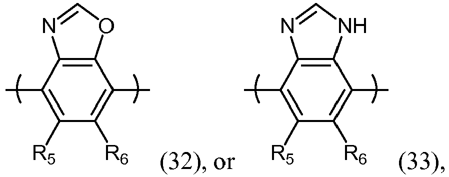 wherein
each of X and Y, independently, is CH₂, O, or S;
each of R₅ and R₆, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R, in which R is H, C₁-C₂₀ alkyl, C₁-C₂₀ alkoxy, aryl, heteroaryl, C₃-C₂₀ cycloalkyl, or C₁-C₂₀ heterocycloalkyl; and
each of R₇ and R₈, independently, is H, C₁-C₂₀ alkyl, C₁-C₂₀ alkoxy, aryl, heteroaryl, C₃-C₂₀ cycloalkyl, or C₃-C₂₀ heterocycloalkyl.

5. The article of claim 4, wherein the second comonomer repeat unit comprises a benzothiadiazole moiety of formula (2), in which each of R₅ and R₆ is H.

6. The article of claim 4, wherein the second comonomer repeat unit comprises a thiazole moiety of formula (23), in which R₅ is hexyl.

7. The article of claim 1, wherein the polymer further comprises a third comonomer repeat unit different from the first and second comonomer repeat units.

8. A polymer, comprising:
a first comonomer repeat unit comprising a silacyclopentadithiophene moiety of formula (1): 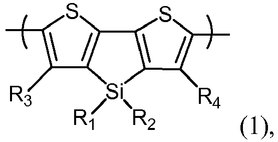
in which each of R₁, R₂, R₃, and R₄, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R; R being H, C₁-C₂₀ alkyl, C₁-C₂₀ alkoxy, aryl, heteroaryl, C₃-C₂₀ cycloalkyl, or C₁-C₂₀ heterocycloalkyl; and
a second comonomer repeat unit comprising a silacyclopentadithiophene moiety of formula (I), a benzothiadiazole moiety, a thiadiazoloquinoxaline moiety, a cyclopentadithiophene moiety, a cyclopentadithiophene oxide moiety, a benzoisothiazole moiety, a benzothiazole moiety, a thiophene oxide moiety, a thienothiophene moiety, a thienothiophene oxide moiety, a dithienothiophene moiety, a dithienothiophene oxide moiety, a tetrahydroisoindole moiety, a fluorenone moiety, a thiazole moiety, a selenophene moiety, a silole moiety, a thiazolothiazole moiety, a cyclopentadithiazole moiety, a naphthothiadiazole moiety, a thienopyrazine moiety, an oxazole moiety, an imidazole moiety, a pyrimidine moiety, a benzoxazole moiety, or a benzimidazole moiety.

9. The polymer of claim 8, wherein each of R₁ and R₂, independently, is C₁-C₂₀ alkyl.

10. The polymer of claim 8, wherein each of R₁ and R₂ is hexyl.

11. The polymer of claim 8, wherein the second comonomer repeat unit comprises a benzothiadiazole moiety of formula (2), a thiadiazoloquinoxaline moiety of formula (3), a cyclopentadithiophene dioxide moiety of formula (4), a cyclopentadithiophene monoxide moiety of formula (5), a benzoisothiazole moiety of formula (6), a benzothiazole moiety of formula (7), a thiophene dioxide moiety of formula (8), a cyclopentadithiophene dioxide moiety of formula (9), a cyclopentadithiophene tetraoxide moiety of formula (10), a thienothiophene moiety of formula (11), a thienothiophene tetraoxide moiety of formula (12), a dithienothiophene moiety of formula (13), a dithienothiophene dioxide moiety of formula (14), a dithienothiophene tetraoxide moiety of formula (15), a tetrahydroisoindole moiety of formula (16), a thienothiophene dioxide moiety of formula (17), a dithienothiophene dioxide moiety of formula (18), a silole moiety of formula (20), a cyclopentadithiophene moiety of formula (21), a fluorenone moiety of formula (22), a thiazole moiety of formula (23), a selenophene moiety of formula (24), a thiazolothiazole moiety of formula (25), a cyclopentadithiazole moiety of formula (26), a naphthothiadiazole moiety of formula (27), a thienopyrazine moiety of formula (28), an oxazole moiety of formula (29), an imidazole moiety of formula (30), a pyrimidine moiety of formula (31), a benzoxazole moiety of formula (32), or a benzimidazole moiety of formula (33): 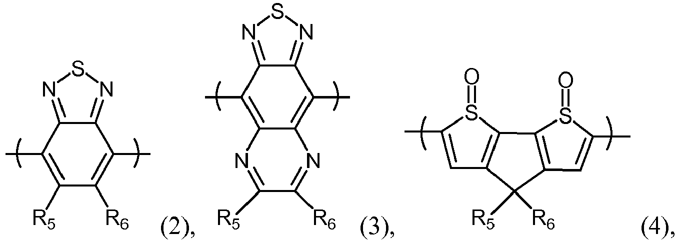 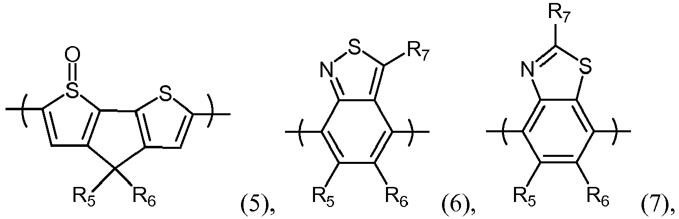 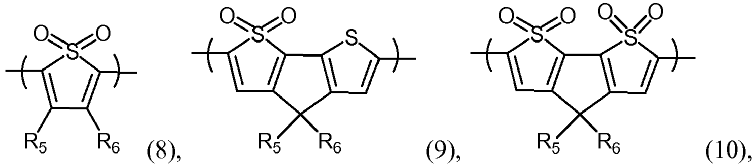 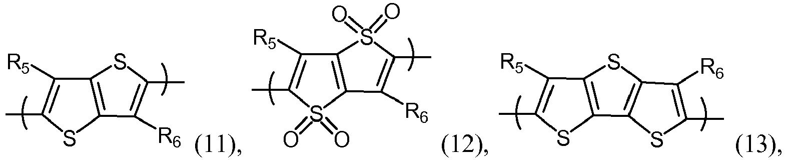 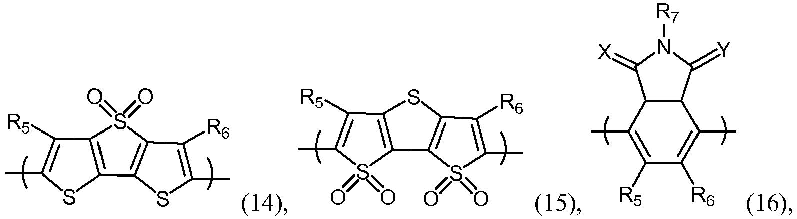 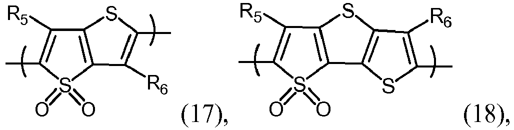 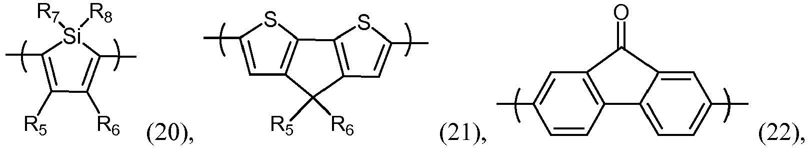 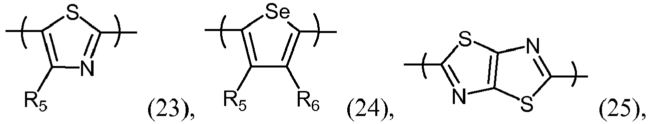 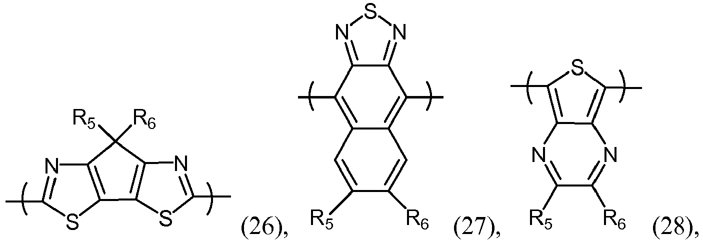 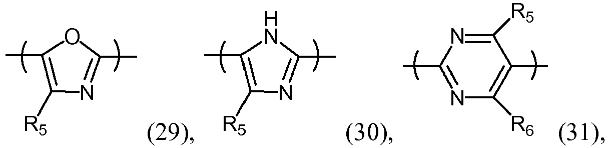 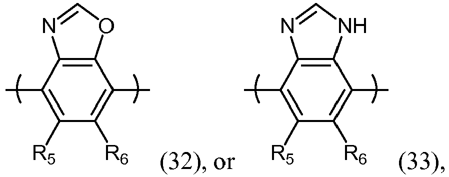 wherein
each of X and Y, independently, is CH₂, O, or S;
each of R₅ and R₆, independently, is H, C₁-C₂₀ alkyl, C₁-C₂₀ alkoxy, C₃-C₂₀ cycloalkyl, C₁-C₂₀ heterocycloalkyl, aryl, heteroaryl, halo, CN, OR, C(O)R, C(O)OR, or SO₂R, in which R is H, C₁-C₂₀ alkyl, C₁-C₂₀ alkoxy, aryl, heteroaryl, C₃-C₂₀ cycloalkyl, or C₁-C₂₀ heterocycloalkyl; and
each of R₇ and R₈, independently, is H, C₁-C₂₀ alkyl, C₁-C₂₀ alkoxy, aryl, heteroaryl, C₃-C₂₀ cycloalkyl, or C₃-C₂₀ heterocycloalkyl.

12. The polymer of claim 11, wherein the second comonomer repeat unit comprises a benzothiadiazole moiety of formula (2), in which each of R₅ and R₆ is H.

13. The polymer of claim 11, wherein the second comonomer repeat unit comprises a thiazole moiety of formula (23), in which R₅ is hexyl.

## Patentansprüche

1. Gegenstand (100; 200), enthaltend:
eine erste Elektrode (120; 220; 240);
eine zweite Elektrode (160; 240; 260); und
ein photoaktives Material (140; 230; 350), das zwischen den ersten (120; 220; 240) und zweiten Elektroden (160; 240; 260) angeordnet ist, wobei das photoaktive Material (140; 230; 350) ein Polymer mit einer ersten Comonomer-Wiederholeinheit und einer zweiten, von der ersten Comonomer-Wiederholeinheit verschiedenen Comonomer-Wiederholeinheit enthält;
**dadurch gekennzeichnet, dass**
die erste Comonomer-Wiederholeinheit einen Silacyclopentadithiophen-Molekülteil der Formel (1) enthält: 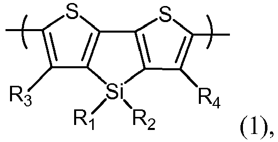 in der R₁, R₂, R₃ und R₄ jeweils unabhängig H, C₁-C₂₀-Alkyl, C₁-C₂₀-Alkoxy, C₃-C₂₀-Cycloalkyl, C₁-C₂₀-Heterocycloalkyl, Aryl, Heteroaryl, Halogen, CN, OR, C(O)R, C(O)OR oder SO₂R sind; wobei R H, C₁-C₂₀-Alkyl, C₁-C₂₀-Alkoxy, Aryl, Heteroaryl, C₃-C₂₀-Cycloalkyl oder C₁-C₂₀-Heterocycloalkyl ist;
die zweite Comonomer-Wiederholeinheit einen Silacyclopentadithiophen-Molekülteil der Formel (I), einen Benzothiadiazol-Molekülteil, einen Thiadiazolochinoxalin-Molekülteil, einen Cyclopentadithiophen-Molekülteil, einen Cyclopentadithiophenoxid-Molekülteil, einen Benzoisothiazol-Molekülteil, einen Benzothiazol-Molekülteil, einen Thiophenoxid-Molekülteil, einen Thienothiophen-Molekülteil, einen Thienothiophenoxid-Molekülteil, einen Dithienothiophen-Molekülteil, einen Dithienothiophenoxid-Molekülteil, einen Tetrahydroisoindol-Molekülteil, einen Fluorenon-Molekülteil, einen Thiazol-Molekülteil, einen Selenophen-Molekülteil, einen Silol-Molekülteil, einen Thiazolothiazol-Molekülteil, einen Cyclopentadithiazol-Molekülteil, einen Naphthothiadiazol-Molekülteil, einen Thienopyrazin-Molekülteil, einen Oxazol-Molekülteil, einen Imidazol-Molekülteil, einen Pyrimidin-Molekülteil, einen Benzoxazol-Molekülteil oder einen Benzimidazol-Molekülteil enthält; und
der Gegenstand als Photovoltaikzelle gestaltet ist.

2. Gegenstand des Anspruchs 1, bei dem R₁ und R₂ jeweils unabhängig C₁-C₂₀-Alkyl sind.

3. Gegenstand des Anspruchs 1, bei dem R₁ und R₂ jeweils Hexyl sind.

4. Gegenstand des Anspruchs 1, bei dem die zweite Comonomer-Wiederholeinheit einen Benzothiadiazol-Molekülteil der Formel (2), einen Thiadiazolochinoxalin-Molekülteil der Formel (3), einen Cyclopentadithiophendioxid-Molekülteil der Formel (4), einen Cyclopentadithiophenmonoxid-Molekülteil der Formel (5), einen Benzoisothiazol-Molekülteil der Formel (6), einen Benzothiazol-Molekülteil der Formel (7), einen Thiophendioxid-Molekülteil der Formel (8), einen Cyclopentadithiophendioxid-Molekülteil der Formel (9), einen Cyclopentadithiophentetraoxid-Molekülteil der Formel (10), einen Thienothiophen-Molekülteil der Formel (11), einen Thienothiophentetraoxid-Molekülteil der Formel (12), einen Dithienothiophen-Molekülteil der Formel (13), einen Dithienothiophendioxid-Molekülteil der Formel (14), einen Dithienothiophentetraoxid-Molekülteil der Formel (15), einen Tetrahydroisoindol-Molekülteil der Formel (16), einen Thienothiophendioxid-Molekülteil der Formel (17), einen Dithienothiophendioxid-Molekülteil der Formel (18), einen Silol-Molekülteil der Formel (20), einen Cyclopentadithiophen-Molekülteil der Formel (21), einen Fluorenon-Molekülteil der Formel (22), einen Thiazol-Molekülteil der Formel (23), einen Selenophen-Molekülteil der Formel (24), einen Thiazolothiazol-Molekülteil der Formel (25), einen Cyclopentadithiazol-Molekülteil der Formel (26), einen Naphthothiadiazol-Molekülteil der Formel (27), einen Thienopyrazin-Molekülteil der Formel (28), einen Oxazol-Molekülteil der Formel (29), einen Imidazol-Molekülteil der Formel (30), einen Pyrimidin-Molekülteil der Formel (31), einen Benzoxazol-Molekülteil der Formel (32) oder einen Benzimidazol-Molekülteil der Formel (33) enthält: 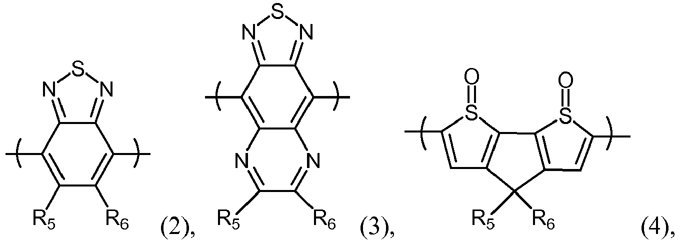 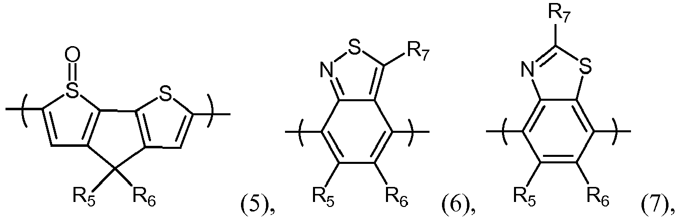 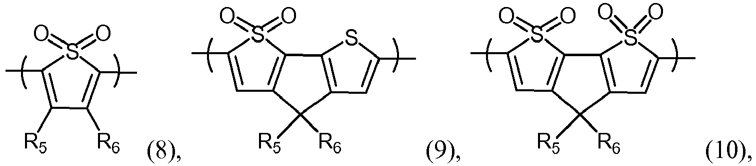 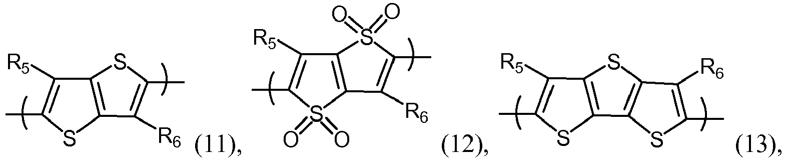 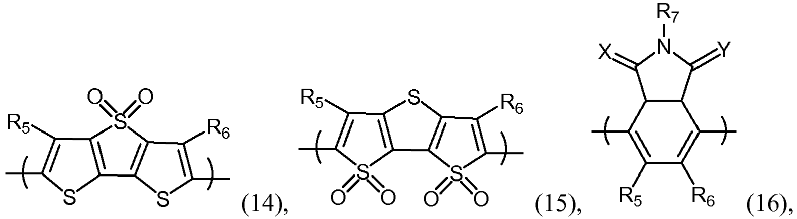 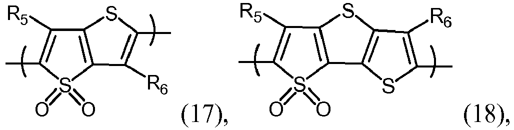 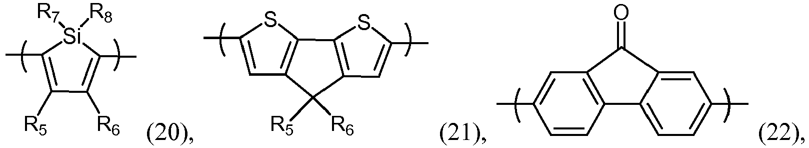 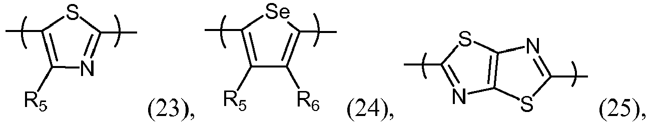 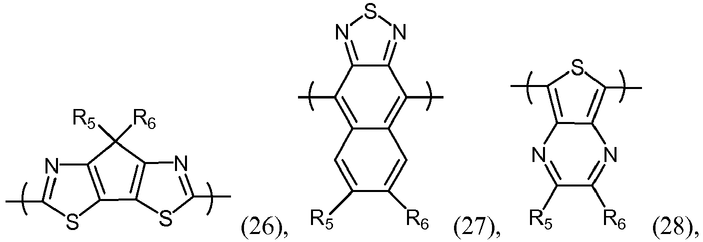 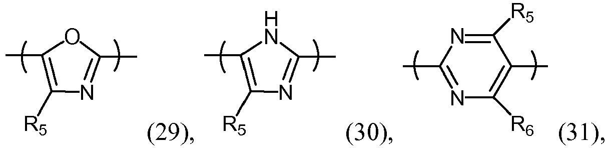 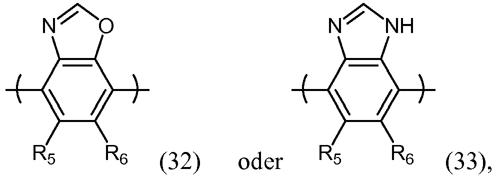 bei denen
X und Y jeweils unabhängig CH₂, O oder S sind;
R₅ und R₆ jeweils unabhängig H, C₁-C₂₀-Alkyl, C₁-C₂₀-Alkoxy, C₃-C₂₀-Cycloalkyl, C₁-C₂₀-Heterocycloalkyl, Aryl, Heteroaryl, Halogen, CN, OR, C(O)R, C(O)OR oder SO₂R sind, in denen R H, C₁-C₂₀-Alkyl, C₁-C₂₀-Alkoxy, Aryl, Heteroaryl, C₃-C₂₀-Cycloalkyl oder C₁-C₂₀-Heterocycloalkyl ist; und
R₇ und R₈ jeweils unabhängig H, C₁-C₂₀-Alkyl, C₁-C₂₀-Alkoxy, Aryl, Heteroaryl, C₃-C₂₀-Cycloalkyl oder C₃-C₂₀-Heterocycloalkyl sind.

5. Gegenstand des Anspruchs 4, bei dem die zweite Comonomer-Wiederholeinheit einen Benzothiadiazol-Molekülteil der Formel (2) enthält, in der R₅ und R₆ jeweils H sind.

6. Gegenstand des Anspruchs 4, bei dem die zweite Comonomer-Wiederholeinheit einen Thiazol-Molekülteil der Formel (23) enthält, in der R₅ Hexyl ist.

7. Gegenstand des Anspruchs 1, bei dem das Polymer weiter eine dritte Comonomer-Wiederholeinheit enthält, die von den ersten und zweiten Comonomer-Wiederholeinheiten verschieden ist.

8. Polymer enthaltend:
eine erste Comonomer-Wiederholeinheit enthaltend einen Silacyclopentadithiophen-Molekülteil der Formel (1): 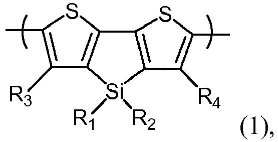 in der R₁, R₂, R₃ und R₄ jeweils unabhängig H, C₁-C₂₀-Alkyl, C₁-C₂₀-Alkoxy, C₃-C₂₀-Cycloalkyl, C₁-C₂₀-Heterocycloalkyl, Aryl, Heteroaryl, Halogen, CN, OR, C(O)R, C(O)OR oder SO₂R sind; wobei R H, C₁-C₂₀-Alkyl, C₁-C₂₀-Alkoxy, Aryl, Heteroaryl, C₃-C₂₀-Cycloalkyl oder C₁-C₂₀-Heterocycloalkyl ist; und
eine zweite Comonomer-Wiederholeinheit enthaltend einen Silacyclopentadithiophen-Molekülteil der Formel (I), einen Benzothiadiazol-Molekülteil, einen Thiadiazolochinoxalin-Molekülteil, einen Cyclopentadithiophen-Molekülteil, einen Cyclopentadithiophenoxid-Molekülteil, einen Benzoisothiazol-Molekülteil, einen Benzothiazol-Molekülteil, einen Thiophenoxid-Molekülteil, einen Thienothiophen-Molekülteil, einen Thienothiophenoxid-Molekülteil, einen Dithienothiophen-Molekülteil, einen Dithienothiophenoxid-Molekülteil, einen Tetrahydroisoindol-Molekülteil, einen Fluorenon-Molekülteil, einen Thiazol-Molekülteil, einen Selenophen-Molekülteil, einen Silol-Molekülteil, einen Thiazolothiazol-Molekülteil, einen Cyclopentadithiazol-Molekülteil, einen Naphthothiadiazol-Molekülteil, einen Thienopyrazin-Molekülteil, einen Oxazol-Molekülteil, einen Imidazol-Molekülteil, einen Pyrimidin-Molekülteil, einen Benzoxazol-Molekülteil oder einen Benzimidazol-Molekülteil.

9. Polymer des Anspruchs 8, bei dem R₁ und R₂ jeweils unabhängig C₁-C₂₀-Alkyl sind.

10. Polymer des Anspruchs 8, bei dem R₁ und R₂ jeweils Hexyl sind.

11. Polymer des Anspruchs 8, bei dem die zweite Comonomer-Wiederholeinheit einen Benzothiadiazol-Molekülteil der Formel (2), einen Thiadiazolochinoxalin-Molekülteil der Formel (3), einen Cyclopentadithiophendioxid-Molekülteil der Formel (4), einen Cyclopentadithiophenmonoxid-Molekülteil der Formel (5), einen Benzoisothiazol-Molekülteil der Formel (6), einen Benzothiazol-Molekülteil der Formel (7), einen Thiophendioxid-Molekülteil der Formel (8), einen Cyclopentadithiophendioxid-Molekülteil der Formel (9), einen Cyclopentadithiophentetraoxid-Molekülteil der Formel (10), einen Thienothiophen-Molekülteil der Formel (11), einen Thienothiophentetraoxid-Molekülteil der Formel (12), einen Dithienothiophen-Molekülteil der Formel (13), einen Dithienothiophendioxid-Molekülteil der Formel (14), einen Dithienothiophentetraoxid-Molekülteil der Formel (15), einen Tetrahydroisoindol-Molekülteil der Formel (16), einen Thienothiophendioxid-Molekülteil der Formel (17), einen Dithienothiophendioxid-Molekülteil der Formel (18), einen Silol-Molekülteil der Formel (20), einen Cyclopentadithiophen-Molekülteil der Formel (21), einen Fluorenon-Molekülteil der Formel (22), einen Thiazol-Molekülteil der Formel (23), einen Selenophen-Molekülteil der Formel (24), einen Thiazolothiazol-Molekülteil der Formel (25), einen Cyclopentadithiazol-Molekülteil der Formel (26), einen Naphthothiadiazol-Molekülteil der Formel (27), einen Thienopyrazin-Molekülteil der Formel (28), einen Oxazol-Molekülteil der Formel (29), einen Imidazol-Molekülteil der Formel (30), einen Pyrimidin-Molekülteil der Formel (31), einen Benzoxazol-Molekülteil der Formel (32) oder einen Benzimidazol-Molekülteil der Formel (33) enthält: 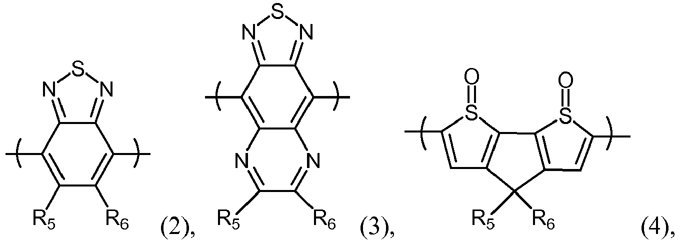 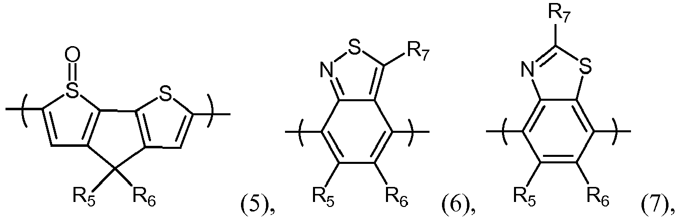 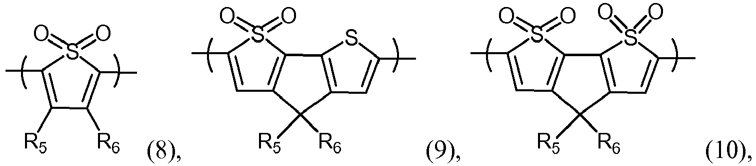 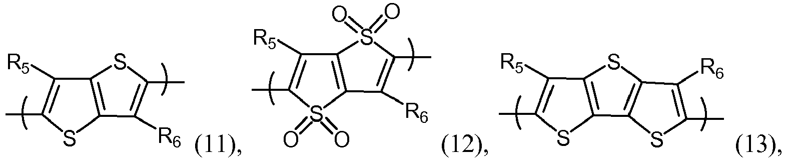 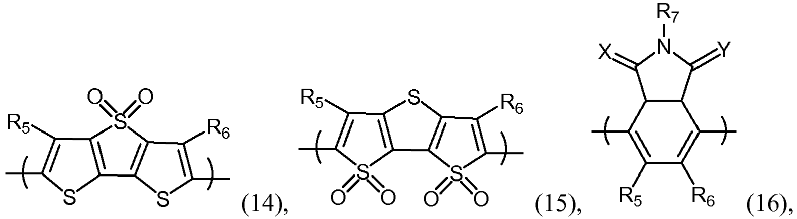 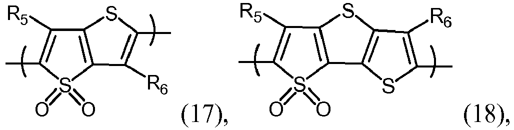 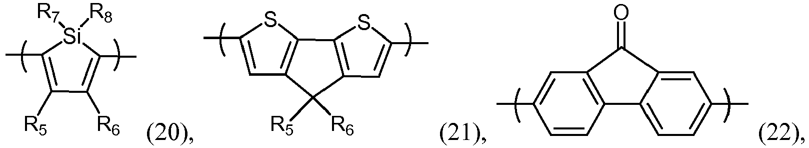 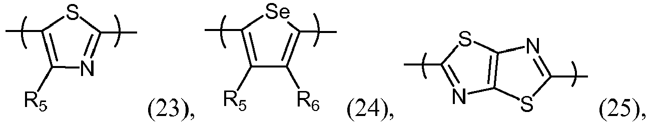 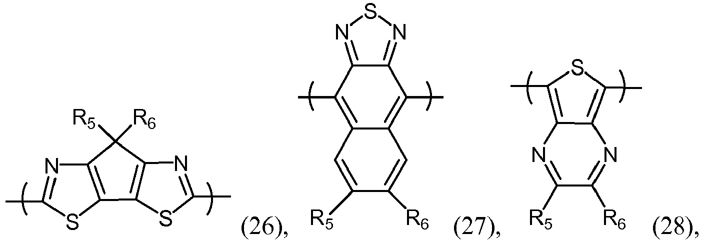 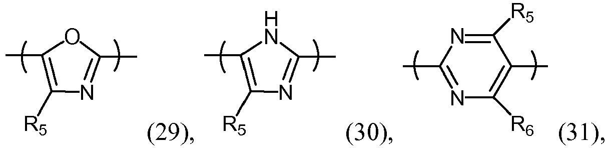 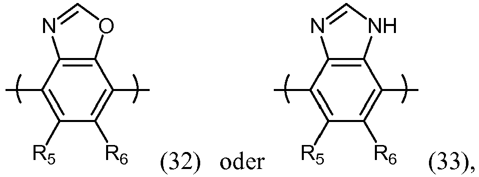 bei denen
X und Y jeweils unabhängig CH₂, O oder S sind;
R₅ und R₆ jeweils unabhängig H, C₁-C₂₀-Alkyl, C₁-C₂₀-Alkoxy, C₃-C₂₀-Cycloalkyl, C₁-C₂₀-Heterocycloalkyl, Aryl, Heteroaryl, Halogen, CN, OR, C(O)R, C(O)OR oder SO₂R sind, in denen R H, C₁-C₂₀-Alkyl, C₁-C₂₀-Alkoxy, Aryl, Heteroaryl, C₃-C₂₀-Cycloalkyl oder C₁-C₂₀-Heterocycloalkyl ist; und
R₇ und R₈ jeweils unabhängig H, C₁-C₂₀-Alkyl, C₁-C₂₀-Alkoxy, Aryl, Heteroaryl, C₃-C₂₀-Cycloalkyl oder C₃-C₂₀-Heterocycloalkyl sind.

12. Polymer des Anspruchs 11, bei dem die zweite Comonomer-Wiederholeinheit einen Benzothiadiazol-Molekülteil der Formel (2) enthält, in der R₅ und R₆ jeweils H sind.

13. Polymer des Anspruchs 11, bei dem die zweite Comonomer-Wiederholeinheit einen Thiazol-Molekülteil der Formel (23) enthält, in der R₅ Hexyl ist.

## Revendications

1. Article (100; 200), comprenant :
une première électrode (120 ; 220 ; 240) ;
une deuxième électrode (160 ; 240; 260) ; et
un matériau photo-actif (140 ; 230; 350) disposé entre la première (120; 220 ; 240) et la deuxième électrode (160 ; 240 ; 260), le matériau photo-actif (140 ; 230 ; 350) comprenant un polymère comportant une premiere moitié répétée de co-monomère et une deuxième moitié répétée de co-monomère différent de la premiere moitié répétée de co-monomère ;
**caractérisé en ce que**
la premiere moitié répétée de co-monomère comprend une moitié de silacyclo-pentadithiophène de formule (1) : 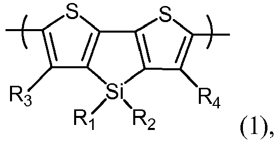 où chacun parmi R₁, R₂, R₃, et R₄, indépendamment, est H, C₁-C₂₀ alkyle, C₁-C₂₀ alcoxy, C₃-C₂₀ cycloalkyle, C₁-C₂₀ hétérocycloalkyle, aryle, hétéroaryle, halogéno, CN, OR, C(O)R, C(O)OR, ou SO₂R, R étant H, C₁-C₂₀ alkyle, C₁-C₂₀ alcoxy, aryle, hétéroaryle, C₃-C₂₀ cycloalkyle, ou C₁-C₂₀ hétérocycloalkyle ;
la deuxième moitié répétée de co-monomère comprend une moitié de silacyclo- pentadithiophène de formule (I), une moitié de benzothiadiazole, une moitié de thiadiazoloquinoxaline, une moitié de cyclopentadithiophène, une moitié d'oxyde de cyclopentadithiophène, une moitié de benzoisothiazole, une moitié de benzothiazole, une moitié d'oxyde de thiophène, une moitié de thiénothiophène, une moitié d'oxyde de thiénothiophène, une moitié de dithiénothiophène, une moitié d'oxyde de dithiénothiophène, une moitié de tétrahydroisoindole, une moitié de fluorénone, une moitié de thiazole, une moitié de sélénophène, une moitié de silole, une moitié de thiazolothiazole, une moitié de cyclopentadithiazole, une moitié de naphtothiadiazole, une moitié de thiénopyrazine, une moitié d'oxazole, une moitié d'imidazole, une moitié de pyrimidine, une moitié de benzoxazole, ou une moitié de benzimidazole ; et
l'article est configuré sous forme de cellule photovoltaïque.

2. Article selon la revendication 1, dans lequel chacun parmi R₁ et R₂, indépendamment, est C₁-C₂₀ alkyle.

3. Article selon la revendication 1, dans lequel chacun parmi R₁ et R₂ est hexyle.

4. Article selon la revendication 1, dans lequel la deuxième moitié répétée de co-monomère comprend une moitié de benzothiadiazole de formule (2), une moitié de thiadiazoloquinoxaline de formule (3), une moitié de dioxyde de cyclopentadithiophène de formule (4), une moitié de monoxyde de cyclopentadithiophène de formule (5), une moitié de benzoisothiazole de formule (6), une moitié de benzothiazole de formule (7), une moitié de dioxyde de thiophène de formule (8), une moitié de dioxyde de cyclopentadithiophène de formule (9), une moitié de tétraoxyde de cyclopentadithiophène de formule (10), une moitié de thiénothiophène de formule (11), une moitié de tétraoxyde de thiénothiophène de formule (12), une moitié de dithiénothiophène de formule (13), une moitié de dioxyde de dithiénothiophène de formule (14), une moitié de tétraoxyde de dithiénothiophène de formule (15), une moitié de tétrahydroisoindole de formule (16), une moitié de dioxyde de thiénothiophène de formule (17), une moitié de dioxyde de dithiénothiophène de formule (18), une moitié de silole de formule (20), une moitié de cyclopentadithiophène de formule (21), une moitié de fluorénone de formule (22), une moitié de thiazole de formule (23), une moitié de sélénophène de formule (24), une moitié de thiazolothiazole de formule (25), une moitié de cyclopentadithiazole de formule (26), une moitié de naphtothiadiazole de formule (27), une moitié de thiénopyrazine de formule (28), une moitié d'oxazole de formule (29), une moitié d'imidazole de formule (30), une moitié de pyrimidine de formule (31), une moitié de benzoxazole de formule (32), ou une moitié de benzimidazole de formule (33) : 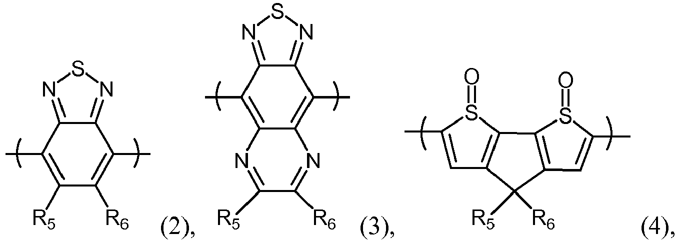 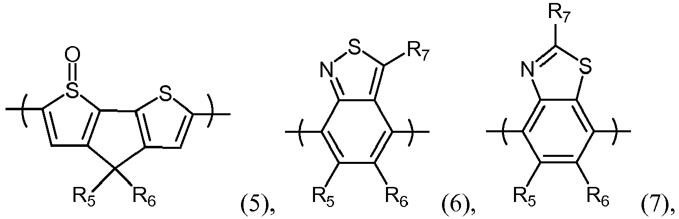 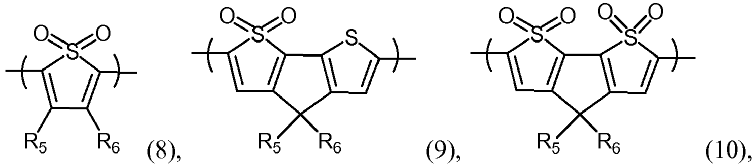 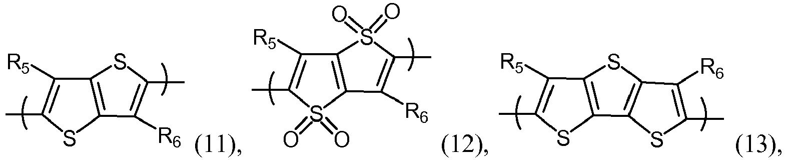 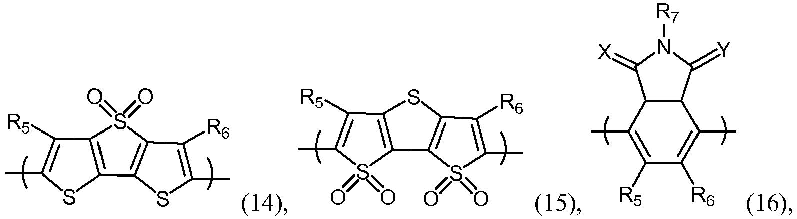 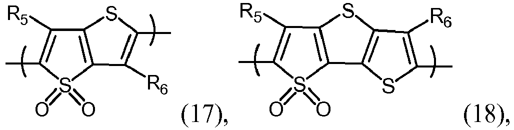 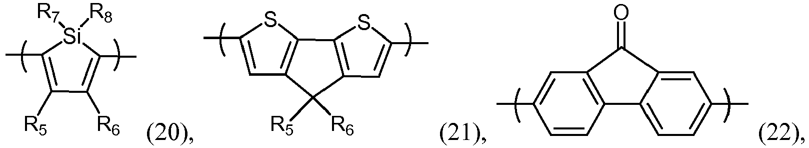 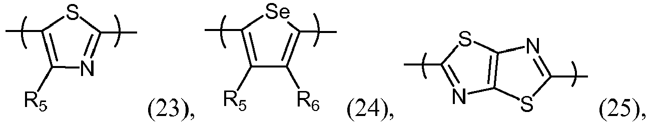 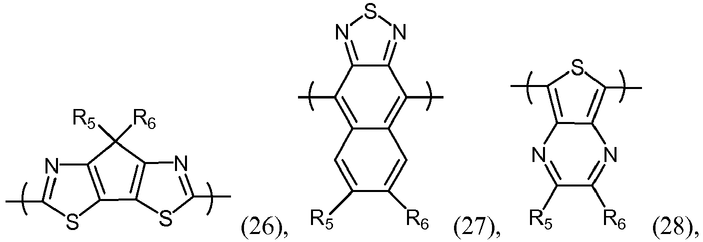 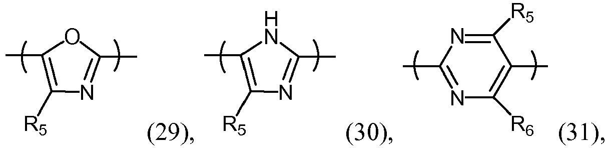 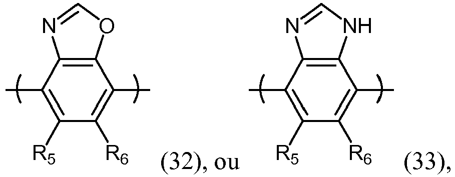 où
chacun parmi X et Y, indépendamment, est CH₂, O, ou S ;
chacun parmi R₅ et R₆, indépendamment, est H, C₁-C₂₀ alkyle, C₁-C₂₀ alcoxy, C₃-C₂₀ cycloalkyle, C₁-C₂₀ hétérocycloalkyle, aryle, hétéroaryle, halogéno, CN, OR, C(O)R, C(O)OR, ou SO₂R, où R est H, C₁-C₂₀ alkyle, C₁-C₂₀ alcoxy, aryle, hétéroaryle, C₃-C₂₀ cycloalkyle, ou C₁-C₂₀ hétérocycloalkyle ; et
chacun parmi R₇ et R₈, indépendamment, est H, C₁-C₂₀ alkyle, C₁-C₂₀ alcoxy, aryle, hétéroaryle, C₃-C₂₀ cycloalkyle, ou C₃-C₂₀ hétérocycloalkyle.

5. Article selon la revendication 4, dans lequel la deuxième moitié répétée de co-monomère comprend une moitié de benzothiadiazole de formule (2), où chacun parmi R₅ et R₆ est H.

6. Article selon la revendication 4, dans lequel la deuxième moitié répétée de co-monomère comprend une moitié de thiazole de formule (23), où R₅ est hexyle.

7. Article selon la revendication 1, dans lequel le polymère comprend en outre une troisième moitié répétée de co-monomère différent du premier et de la deuxième moitié répétée de co-monomère.

8. Polymère, comprenant :
une premiere moitié répétée de co-monomère comprenant une moitié de silacyclopentadithiophène de formule (1) : 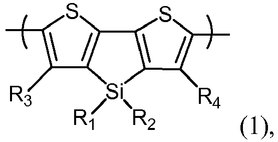 où chacun parmi R₁, R₂, R₃, et R₄, indépendamment, est H, C₁-C₂₀ alkyle, C₁-C₂₀ alcoxy, C₃-C₂₀ cycloalkyle, C₁-C₂₀ hétérocycloalkyle, aryle, hétéroaryle, halogéno, CN, OR, C(O)R, C(O)OR, ou SO₂R, R étant H, C₁-C₂₀ alkyle, C₁-C₂₀ alcoxy, aryle, hétéroaryle, C₃-C₂₀ cycloalkyle, ou C₁-C₂₀ hétérocycloalkyle ; et
une deuxième moitié répétée de co-monomère comprenant une moitié de silacyclopentadithiophène de formule (I), une moitié de benzothiadiazole, une moitié de thiadiazoloquinoxaline, une moitié de cyclopentadithiophène, une moitié d'oxyde de cyclopentadithiophène, une moitié de benzoisothiazole, une moitié de benzothiazole, une moitié d'oxyde de thiophène, une moitié de thiénothiophène, une moitié d'oxyde de thiénothiophène, une moitié de dithiénothiophène, une moitié d'oxyde de dithiénothiophène, une moitié de tétrahydroisoindole, une moitié de fluorénone, une moitié de thiazole, une moitié de sélénophène, une moitié de silole, une moitié de thiazolothiazole, une moitié de cyclopentadithiazole, une moitié de naphtothiadiazole, une moitié de thiénopyrazine, une moitié d'oxazole, une moitié d'imidazole, une moitié de pyrimidine, une moitié de benzoxazole, ou une moitié de benzimidazole.

9. Polymère selon la revendication 8, dans lequel chacun parmi R₁ et R₂, indépendamment, est C₁-C₂₀ alkyle.

10. Polymère selon la revendication 8, dans lequel chacun parmi R₁ et R₂ est hexyle.

11. Polymère selon la revendication 8, dans lequel la deuxième moitié répétée de co-monomère comprend une moitié de benzothiadiazole de formule (2), une moitié de thiadiazoloquinoxaline de formule (3), une moitié de dioxyde de cyclopentadithiophène de formule (4), une moitié de monoxyde de cyclopentadithiophène de formule (5), une moitié de benzoisothiazole de formule (6), une moitié de benzothiazole de formule (7), une moitié de dioxyde de thiophène de formule (8), une moitié de dioxyde de cyclopentadithiophène de formule (9), une moitié de tétraoxyde de cyclopentadithiophène de formule (10), une moitié de thiénothiophène de formule (11), une moitié de tétraoxyde de thiénothiophène de formule (12), une moitié de dithiénothiophène de formule (13), une moitié de dioxyde de dithiénothiophène de formule (14), une moitié de tétraoxyde de dithiénothiophène de formule (15), une moitié de tétrahydroisoindole de formule (16), une moitié de dioxyde de thiénothiophène de formule (17), une moitié de dioxyde de dithiénothiophène de formule (18), une moitié de silole de formule (20), une moitié de cyclopentadithiophène de formule (21), une moitié de fluorénone de formule (22), une moitié de thiazole de formule (23), une moitié de sélénophène de formule (24), une moitié de thiazolothiazole de formule (25), une moitié de cyclopentadithiazole de formule (26), une moitié de naphtothiadiazole de formule (27), une moitié de thiénopyrazine de formule (28), une moitié d'oxazole de formule (29), une moitié d'imidazole de formule (30), une moitié de pyrimidine de formule (31), une moitié de benzoxazole de formule (32), ou une moitié de benzimidazole de formule (33) : 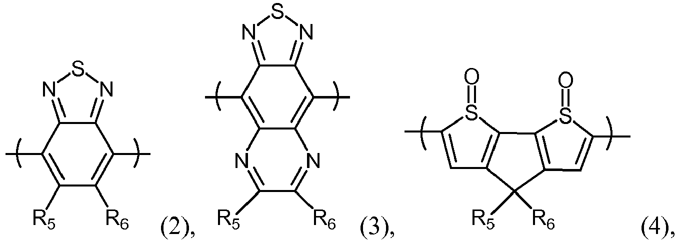 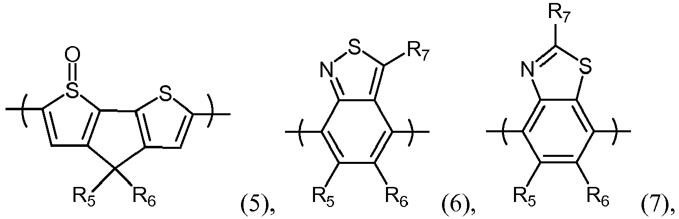 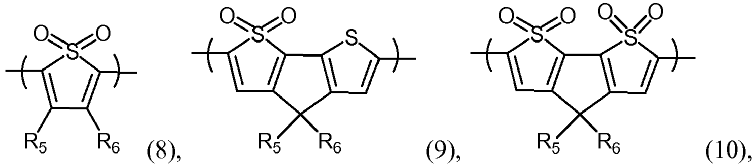 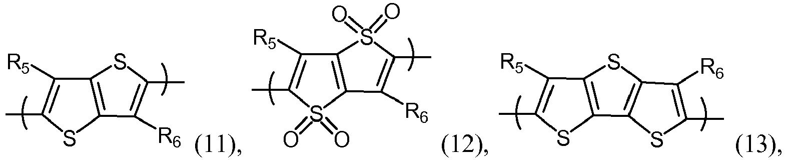 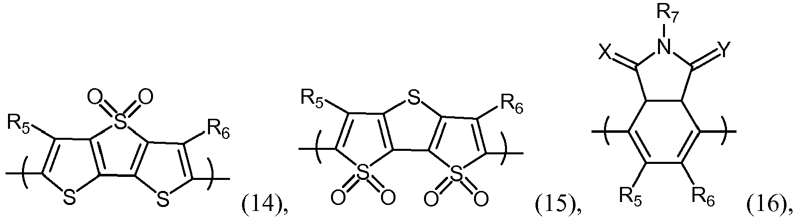 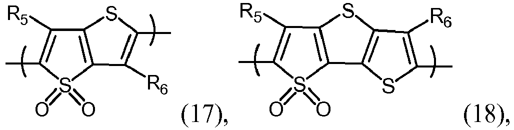 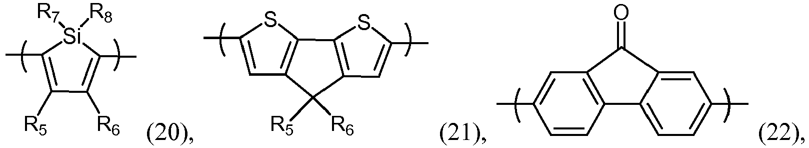 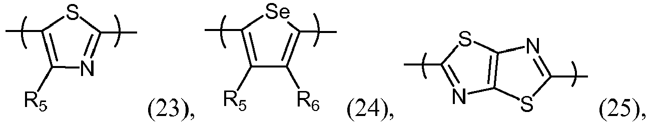 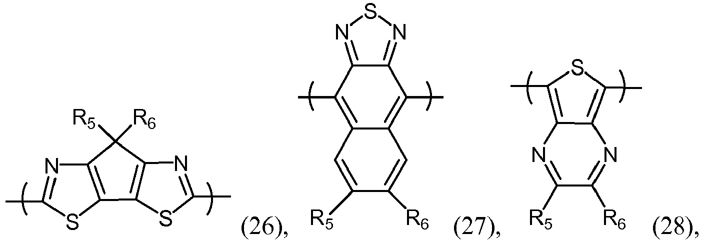 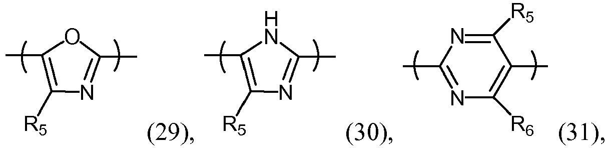 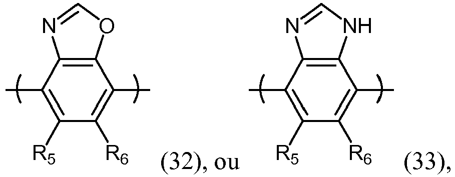 où
chacun parmi X et Y, indépendamment, est CH₂, O, ou S ;
chacun parmi R₅ et R₆, indépendamment, est H, C₁-C₂₀ alkyle, C₁-C₂₀ alcoxy, C₃-C₂₀ cycloalkyle, C₁-C₂₀ hétérocycloalkyle, aryle, hétéroaryle, halogéno, CN, OR, C(O)R, C(O)OR, ou SO₂R, où R est H, C₁-C₂₀ alkyle, C₁-C₂₀ alcoxy, aryle, hétéroaryle, C₃-C₂₀ cycloalkyle, ou C₁-C₂₀ hétérocycloalkyle ; et
chacun parmi R₇ et R₈, indépendamment, est H, C₁-C₂₀ alkyle, C₁-C₂₀ alcoxy, aryle, hétéroaryle, C₃-C₂₀ cycloalkyle, ou C₃-C₂₀ hétérocycloalkyle.

12. Polymère selon la revendication 11, dans lequel la deuxième moitié répétée de co-monomère comprend une moitié de benzothiadiazole de formule (2), où chacun parmi R₅ et R₆ est H.

13. Polymère selon la revendication 11, dans lequel la deuxième moitié répétée de co-monomère comprend une moitié de thiazole de formule (23), où R₅ est hexyle.
